Europäisches Patentamt

European Patent Office

Office européen des brevets

(19)

(11) **EP 1 318 583 A2**

(12) **EUROPEAN PATENT APPLICATION**

(43) Date of publication:
**11.06.2003 Bulletin 2003/24**

(51) Int Cl.⁷: **H01S 5/40**

(21) Application number: **02257872.8**

(22) Date of filing: **14.11.2002**

(84) Designated Contracting States:
**AT BE BG CH CY CZ DE DK EE ES FI FR GB GR
IE IT LI LU MC NL PT SE SK TR**
Designated Extension States:
**AL LT LV MK RO SI**

(30) Priority: **14.11.2001 JP 2001349301
19.02.2002 JP 2002042240
19.03.2002 JP 2002077353
25.10.2002 JP 2002310961**

(71) Applicant: **THE FURUKAWA ELECTRIC CO., LTD.
Tokyo 100-8322 (JP)**

(72) Inventors:
• **Tsukiji, Naoki, c/o The Furukawa Electric Co., Ltd
Tokyo 100-8322 (JP)**
• **Yoshida, Junji,
c/o The Furukawa Electric Co., Ltd
Tokyo 100-8322 (JP)**
• **Kimura, Toshio,
c/o The Furukawa Electric Co., Ltd
Tokyo 100-8322 (JP)**
• **Namiki, Shu, c/o The Furukawa Electric Co., Ltd
Tokyo 100-8322 (JP)**

(74) Representative: **Nicholls, Michael John
J.A. KEMP & CO.
14, South Square
Gray's Inn
London WC1R 5JJ (GB)**

(54) **Semiconductor laser with two active layers and optical fiber amplifier using the same**

(57) A semiconductor laser device has two active layers (4A, 4B) laminated on different portions of a n-InP substrate (1). Two stripes (15, 16) emit laser beams. Further, an electric current driving section (20) applies a bias current to the active layers (4A, 4B) via an electrode (8). A modulation signal applying section (21) generates a modulation signal that modulates the bias current, and superposes a modulation signal to the bias current.

FIG.1

EP 1 318 583 A2

**Description**

BACKGROUND OF THE INVENTION

1) Field of the Invention

The present invention relates to a semiconductor laser device that has two stripe structures, a semiconductor laser module and an optical fiber amplifier and that is compact and easy to manufacture, and achieves high output power while reducing Stimulated Brillouin scattering in Raman amplifier and the degree of polarization of the laser beam emitted from the semiconductor laser device.

2) Description of the Related Art

Conventionally in an optical fiber amplifier using Raman amplification scheme, for example, it is known that a plurality of semiconductor laser devices are used as excitation light sources so that a high-output excitation light source is realized and a high-Raman gain optical fiber amplifier can be realized by using it. In the Raman amplification, since the signal light is amplified in a state that polarization directions of the signal light and the exciting light correspond with each other, it is necessary to reduce the influence of a deviation of a plane of polarization between the signal light and the exciting light as much as possible. For this reason, polarization of the exciting light is nullified (depolarization) so that the degree of polarization (DOP) is reduced.

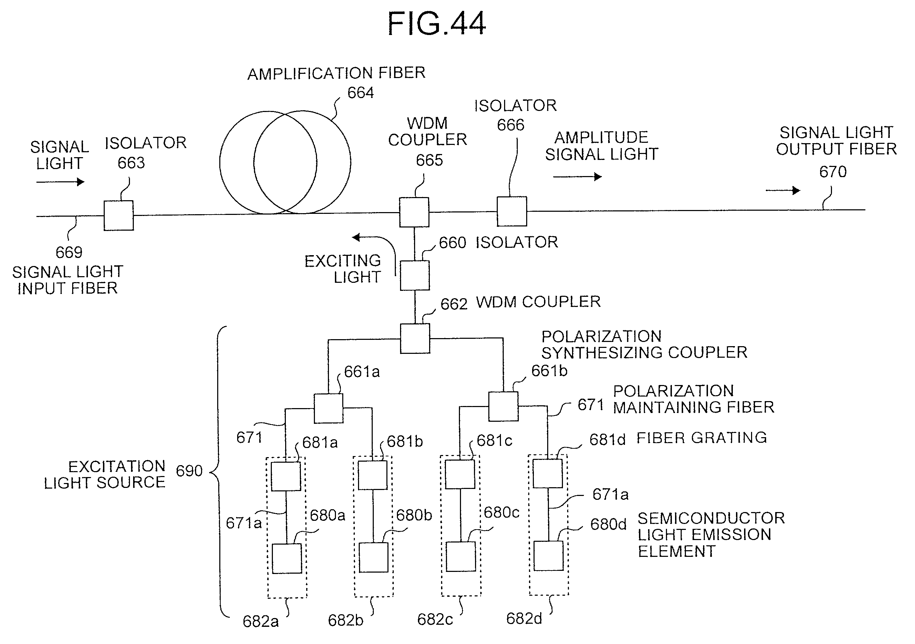

Fig. 44 is a block diagram that shows one example of a structure of a conventional Raman amplifier used in a WDM communication system. As shown in Fig. 44, the conventional Raman amplifier includes semiconductor laser modules 682a through 682d. Each semiconductor laser module includes a Fabry-Perot type semiconductor light emission element and a fiber grating. That is, the semiconductor laser modules 682a through 682d include Fabry-Perot type semiconductor light emission elements 680a through 680d and fiber gratings 681a through 681d. The semiconductor laser modules 682a and 682b output laser beams, which are the excitation light source, to a polarization beam combiner 661a. The semiconductor laser modules 682c and 682d output laser beams, which are the excitation light source, to a polarization beam combiner 661b. The semiconductor laser modules 682a and 682b emit laser beams of same wavelengths and the polarization beam combiner 661a combines (multiplexes) these two laser beams to obtain light having perpendicularly polarized planes. Similarly, the respective semiconductor laser modules 682c and 682d emit laser beams of same wavelength and the polarization beam combiner 661b combines these two laser beams to obtain light having perpendicularly polarized planes. The polarization beam combiners 661a and 661b output the polarization multiplexed laser beams to a WDM coupler 662. The laser beams output from the polarization beam combiners 661a and 661b have different wavelengths.

The WDM coupler 662 combines the laser beams output from the polarization beam combiners 661a and 661b via an isolator 660, and outputs the combined laser beam as an exciting light to an amplification fiber 664 via a WDM coupler 665. A signal light to be amplified is also input into the amplification fiber 664 from a signal light input fiber 669 via an isolator 663. The signal light is combined with the exciting light and the signal light is thus Raman-amplified.

When the laser beams to be polarization-multiplexed are emitted from different semiconductor elements, the process of fabrication of the optical fiber amplifier become complicated and the optical fiber amplifier becomes bulky. To overcome this drawback, a technique of fabricating the Raman amplifier using a semiconductor laser device having two light emission areas at one chip is proposed. As a result of this technique, the process of fabrication of the optical fiber amplifier is simplified, and since a plurality of stripes are mounted on the same substrate, the semiconductor laser device itself can be miniaturized.

On the other hand, when a semiconductor laser element having a structure of plural stripes, particularly a structure of two stripes (W-stripe structure) is used in the Raman amplifier, a new problem arises. In other words, when the semiconductor laser element having the W-stripe structure is used, DOP is not reduced as compared with when separated semiconductor elements are polarization-multiplexed.

When DOP is not reduced, the degree of polarization of laser beam from the excitation light source is not nullified. Since the amplification gain in the Raman amplifier is determined by the intensity of the exciting laser beam component having the same polarization as that of the signal light, when the laser beam from the excitation light source is polarized to a specified direction, the amplification gain in the Raman amplifier changes due to the polarization direction of the signal light. In other words, since a stable amplification gain cannot be obtained, the semiconductor laser element having the W-stripe structure is not suitable for use as an excitation light source of the Raman amplifier.

The cause of the difference in the reduction of DOP is as follows. In the independent semiconductor laser elements as shown in Fig. 44, even when the oscillation wavelengths of each of the semiconductor laser elements are set to be uniform at the design stage, the oscillation wavelengths are not exactly equal, although the difference is very small, due to scattering in actual production. On the contrary, in the W-stripe structure, at the actual production step, a cleavage to allow for an epitaxial growth and to form a reflection end surface is normally formed in exactly identically for each stripe. Therefore, the structures of the stripes are exactly identical, and thus the oscillation wavelengths are the same. The difference in the reduction of DOP occurs due to such a difference in the structures.

Therefore, in order to reduce DOP in the semiconductor laser element having the W-stripe structure, for example, end faces may be formed separately by cleavage so that resonator lengths of the respective stripes are different. However, since the distance between the stripes in the semiconductor laser element is only about a several hundred μm, it is neither easy nor realistic to carry out cleavage separately.

On the contrary, as shown in Fig. 44, in the structure that the independent semiconductor laser elements are polarization-multiplexed, DOP can be reduced, and the amplification gain which is stabilized regardless of the polarization direction of the signal light can be obtained as a Raman gain. However, the production process of the Raman amplifier having the structure shown in Fig. 44 is complex and further it is difficult to miniaturize the entire device.

On the other hand, when semiconductor laser elements are used as the excitation light sources of a distribution type amplifier such as the Raman amplifier, it is preferable that the exciting light output power is increased in order to increase the Raman amplification gain. However, when its peak value is high, stimulated Brillouin scattering occurs, and this results in noise. It is essential to increase the threshold value at which the stimulated Brillouin scattering occurs.

SUMMARY OF THE INVENTION

It is also an object of the present invention to realize a semiconductor laser device and a semiconductor laser module which are suitable for an excitation light source for the Raman amplifier or the like, are compact and easily produced, having a small degree of polarization and capable of suppressing stimulated Brillouin scattering, and to provide an optical fiber amplifier which enables stable and high-gain amplification that does not depend on the direction of polarization of the signal light.

The semiconductor laser device according to one aspect of the present invention has a first stripe structure that has a first active layer laminated on one area of a semiconductor substrate and that emits a first laser beam, a second stripe structure that has a second active layer laminated on another area of the semiconductor substrate and that emits a second laser beam, an electrode laminated on the first active layer and the second active layer, an electric current bias unit that injects a bias current into the first active layer and the second active layer via the electrode, and a modulation unit that generates a modulation signal which modulates the bias current and superposes the modulation signal on the bias current.

The semiconductor laser device according to another aspect of the present invention has a first stripe structure that has a first active layer laminated on one area of a semiconductor substrate and a first diffraction grating which is arranged on one area in the vicinity of the first active layer and that selects a laser beam having a plurality of longitudinal oscillation modes having a specified center wavelength and emits a first laser beam, a second stripe structure that has a second active layer laminated on another area of the semiconductor substrate and a second diffracting grating which is arranged on one area in the vicinity of the second active layer and that selects a laser beam having a plurality of longitudinal oscillation modes having the specified center wavelength and emits a second laser beam, an electrode laminated on the first active layer and the second active layer, an electric current bias unit that injects a bias current into the first active layer and the second active layer via the electrode, and a modulation unit which generates a modulation signal which modulates the bias current and superposes the modulation signal on the bias current.

The semiconductor laser module according to still another aspect of the present invention has the semiconductor laser device described above, a first lens from which the first laser beam and the second laser beam emitted from the semiconductor laser device enter and which separates to widen the distance between the first laser beam and the second laser beam, a polarization rotating unit in which only one of the first laser beam and the second laser beam passed through the first lens enters and that rotates the plane of polarization of the entering laser beam by a predetermined angle, a polarization beam combining unit that has a first port from which the first laser beam from the first lens or the polarization rotating unit enters, a second port from which the second laser beam from the first lens or the polarization rotating unit enters, and a third port in which the first laser beam emitted from the first port and the second laser beam emitted from the second port are multiplexed and from which the multiplexed laser beam is emitted, and an optical fiber that receives the laser beam emitted from the third port of the polarization beam combining unit and transmits it to the outside.

The semiconductor laser module according to still another aspect of the present invention has a first semiconductor laser device that has a first active layer laminated on a semiconductor substrate and that emits a first laser beam, a second semiconductor laser device that has a second active layer laminated on the semiconductor substrate and that emits a second laser beam, an electric current bias unit that injects a bias current into the first active layer and the second active layer, a first modulation unit that generates a first modulation signal which modulates the bias current injected into the first active layer and superposes the first modulation signal on the bias current, a second modulation unit that generates a second modulation signal by dephasing the first modulation signal produced by the first modulation unit by 180° and superposes the second modulation signal on the bias current, a polarization beam combining unit that combines the first laser beam output from the first semiconductor laser device and the second laser beam output from the second semiconductor laser device, and a depolarizer that depolarizes the polarized laser beam output from the polarization beam combining unit.

The semiconductor laser module according to still another aspect of the present invention has a first semiconductor laser device that has a first active layer laminated on a semiconductor substrate and a first diffraction grating which is arranged on one area in the vicinity of the first active layer and that selects a laser beam having a plurality of longitudinal oscillation modes having a specified center wavelength, and emits a first laser beam, a second semiconductor laser device that has a second active layer laminated on the semiconductor substrate and a second diffraction grating which is arranged on one area in the vicinity of the second active layer and that selects a laser beam having a plurality of longitudinal oscillation modes having a specified center wavelength, and emits a second laser beam, an electric current bias unit that injects a bias current into the first active layer and the second active layer, a first modulation unit that generates a first modulation signal which modulates the bias current injected into the first active layer and superposes the first modulation signal on the bias current, a second modulation unit that generates a second modulation signal by dephasing the first modulation signal produced by the first modulation unit by 180° and superposes the second modulation signal on the bias current, a polarization beam combining unit that combines the first laser beam output from the first semiconductor laser device and the second laser beam output from the second semiconductor laser device, and a depolarizer that depolarizers the polarized laser beam output from the polarization beam combining unit.

The optical fiber amplifier according to still another aspect of the present invention has the semiconductor laser device or the semiconductor laser module mentioned above, an amplification optical fiber, and a coupler that combines the exciting light output from the semiconductor laser device or the semiconductor laser module and the signal light propagated inside the amplification optical fiber.

These and other objects, features and advantages of the present invention are specifically set forth in or will become apparent from the following detailed descriptions of the invention when read in conjunction with the accompanying drawings.

BRIEF DESCRIPTION OF THE DRAWINGS

Fig. 1 is a longitudinal sectional view that shows a structure of a semiconductor laser device according to the first embodiment of the present invention.
Fig. 2 is a sectional view of the semiconductor laser device shown in Fig. 1 taken along the line A-A.
Fig. 3 is a graph that shows a change in the optical output with time when a modulation frequency signal is superposed.

Fig. 4 is a graph that shows a modulation principle when a modulation frequency signal is applied to an electric current-optical output characteristic of a semiconductor laser device.
Fig. 5 is a graph that shows a change in the driving current with time when a modulation frequency signal is superposed.
Fig. 6 is a graph that shows a change of the wavelength with a change in the electric current.
Fig. 7 is a graph that shows a frequency characteristic of RIN when the modulation frequency signal is superposed.
Fig. 8A and Fig. 8B are graphs that show that a threshold value of stimulated Brillouin scattering is relatively increased.
Fig. 9 is a graph that shows a change of a spectrum width with a change of amplitude of the modulation frequency signal.
Fig. 10 is a graph that shows a change of the threshold value of the stimulated Brillouin scattering with the change of the spectrum width.
Fig. 11 is a longitudinal sectional view that shows a structure of a semiconductor laser device according to the second embodiment of the present invention.
Fig. 12 is a longitudinal sectional view that shows a structure of a semiconductor laser device according to the third embodiment of the present invention.
Fig. 13 is a sectional view of the semiconductor laser device shown in Fig. 12 taken along the line A-A.
Fig. 14 is a graph that shows an oscillation wavelength spectrum having a plurality of longitudinal oscillation modes.
Fig. 15A and 15B are graphs that show the relationship between multiple longitudinal oscillation modes and a single longitudinal oscillation mode and the relationship between the longitudinal oscillation modes and the stimulated Brillouin scattering in the third embodiment.
Fig. 16 is a graph that shows a compound oscillation frequency wavelength spectrum.
Fig. 17 is a longitudinal sectional view that shows a structure of a semiconductor laser device according to the fourth embodiment of the present invention.
Fig. 18 shows a variation of the semiconductor laser device according to the fourth embodiment of the present invention.
Fig. 19 shows a variation of the semiconductor laser device according to the fourth embodiment of the present invention.
Fig. 20 shows a variation of the semiconductor laser device according to the fourth embodiment of the present invention.
Fig. 21 is a longitudinal sectional view that shows a structure of a semiconductor laser device according to the fifth embodiment of the present invention.
Fig. 22 is a view showing frame format of the structure of the semiconductor laser module according to the fifth embodiment of the present invention.

Fig. 23A is a side view that shows the structure of a prism, and Fig. 23B is a plan view of Fig. 23A

Fig. 24A is a plan view of a holder member which houses the prism, a half-wave plate, and a polarization beam combining member, Fig. 24B is a side view of the holder, and Fig. 24C is a front view of the holder.

Fig. 25 explains a depolarizer used in the sixth embodiment of the present invention.

Fig. 26 shows a section of a polarization-maintaining fiber required for the depolarizer shown in Fig. 25.

Fig. 27A and Fig. 27B are graphs that show the depolarization result of laser beam having a single longitudinal oscillation mode.

Fig. 28 shows a structure of a laser module according to the sixth embodiment of the present invention.

Fig. 29 shows the status of the laser beam on each plane of polarization after polarization synthesis and after depolarization in the laser module shown in Fig. 28.

Fig. 30A and Fig. 30B are graphs that show polarization status and spectrum waveform in each longitudinal oscillation mode in the sixth embodiment of the present invention.

Fig. 31 shows a structure of a laser module according to the seventh embodiment of the present invention.

Fig. 32 is an oblique schematic view of a polarization beam combiner.

Fig. 33 shows a structure of a laser module according to the eighth embodiment of the present invention.

Fig. 34 shows a structure of a laser module according to the ninth embodiment of the present invention.

Fig. 35 shows a structure of a laser module according to the tenth embodiment of the present invention.

Fig. 36 shows the structure of a first variation of the laser module according to the tenth embodiment of the present invention.

Fig. 37 shows the structure of a second variation of the laser module according to the tenth embodiment of the present invention.

Fig. 38 shows the structure of a third variation of the laser module according to the tenth embodiment of the present invention.

Fig. 39 is a cutaway view of a single stripe type semiconductor laser device that can output laser beam having a plurality of longitudinal oscillation modes.

Fig. 40 shows an example of a Raman amplifier.

Fig. 41 shows another example of a Raman amplifier.

Fig. 42 shows still another example of a Raman amplifier.

Fig. 43 is a schematic drawing of a WDM communication system.

Fig. 44 is a block diagram of a conventional optical fiber amplifier.

DETAILED DESCRIPTIONS

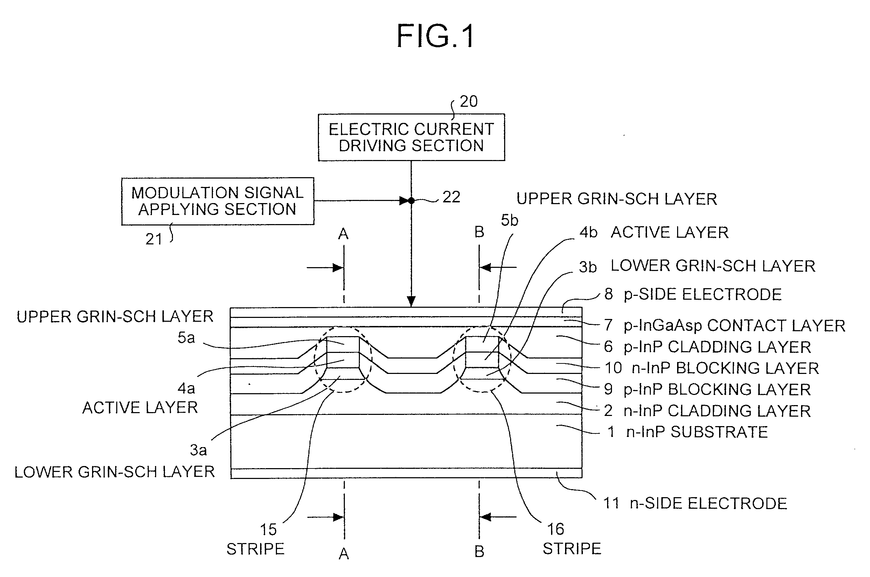

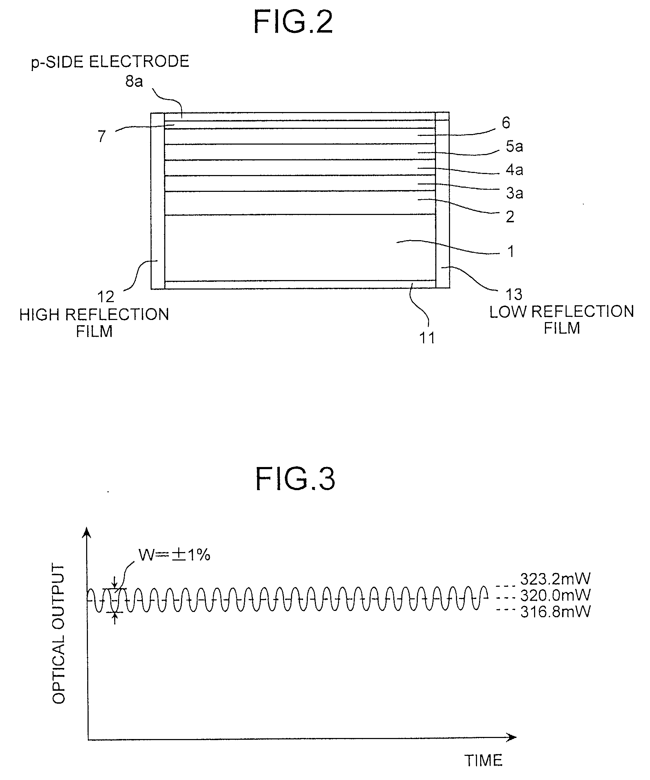

The first embodiment of the present invention will be explained. Fig. 1 is a longitudinal sectional view in a longitudinal direction of a semiconductor laser device according to the first embodiment of the present invention. Fig. 2 is a sectional view of the semiconductor laser device shown in Fig. 1 taken along the line A-A. A sectional view along the line B-B shall be the same as the sectional view taken along the line A-A and so it is not shown.

The semiconductor laser device according to the first embodiment is constituted so that, as shown in Fig. 1, an n-InP cladding layer 2 is laminated on an n-InP substrate 1. Moreover, on the line A-A shown in Fig. 1, a lower GRIN-SCH layer 3a, an active layer 4a, and an upper GRIN-SCH layer 5a are laminated in a mesa shape. These layers form a stripe 15. Similarly, on the line B-B, a lower GRIN-SCH layer 3b, an active layer 4b and an upper GRIN-SCH layer 5b are laminated in a mesa shape. These layers form another stripe 16. The stripe 15 is separated from the stripe 16 by a space. The section other than the stripes 15 and 16 has a structure such that a p-InP blocking layer 9 and an n-InP blocking layer 10 are sequentially laminated on the n-InP cladding layer 2. The flow of the injected electric current is confined only to the stripes 15 and 16. Moreover, a p-InP cladding layer 6p-InP cladding layer 6 is laminated on the upper GRIN-SCH layers 5a and 5b and the n-InP blocking layer 10. A p-InGaAsP contact layer 7 and a p-side electrode 8 are laminated sequentially on the p-InP cladding layer 6. Moreover, an n-side electrode 11 is laminated on the other surface of the n-InP substrate 1.

The n-InP cladding layer 2 functions as a buffer layer as well. The stripes 15 and 16 are sandwiched between the n-InP cladding layer 2 and the p-InP cladding layer 6 so that the semiconductor laser device of the first embodiment has a double hetero structure, and because the carrier is confined effectively, high radiation efficiency is achieved.

It is advantageous in view of high output that the active layers 4a and 4b adopt, for example, a compressive strain quantum well structure when a lattice mismatching of each well in MQW with respect to the n-InP substrate 1 is in a range of 0.5% to 1.5%, and use a multiple quantum well structure in which a number of wells is about 5. Moreover, in the strain quantum well structure, when its barrier layer adopts a strain compensating structure composed by introducing tensile strain opposite to the strain of the well layer, a lattice matching condition can be satisfied equivalently. For this reason, it is not necessary to provide an upper limit of a degree of the lattice mismatching of the well layer.

The stripe 15 is composed of a laminated structure of the lower section of the GRIN-SCH layer 3a, the active layer 4a and the upper section of the GRIN-SCH layer 5a, and this forms a so-called GRIN-SCH-MQW (Graded Index-Separate Confinement Hetero structure Multi Quantum Well) active layer. This enables the carrier to be confined more effectively, and the semiconductor laser device of the first embodiment has high radiative recombination as well as the double hetero structure. This can be applied to the stripe 16 as well.

In the structures of the section taken along the line A-A and the section taken along the line B-B, as shown in Fig. 2, a low reflection film 13 is arranged on an entire surface of a radiation end surface (right end surface in Fig. 2), and a high reflection film 12 is arranged on an entire surface of a reflection end surface (left end surface in Fig. 2). Moreover, the p-side electrode 8 is arranged on an entire surface of the p-InGaAsP contact layer 7.

The high reflection film 12 has a reflectivity of more than 80%, or, ideally, more than 98%. Meanwhile, the low reflection film 13 serves to prevent reflection of a laser beam on the radiation end surface. Therefore, the low reflection film 13 has a reflectivity of less than 5%, or, ideally, 1%. However, the low reflection film 13 is optimized according to a resonator length.

In the semiconductor laser device according to the first embodiment, an electric current is injected from the p-side electrode 8 so that radiative recombination current occurs on the stripes 15 and 16. A light generated by this is amplified by a resonator formed by the high reflection film 12 and the low reflection film 13, and stimulated emission occurs so that the laser beam is radiated from the low reflection film 13.

The semiconductor laser device according to the first embodiment has an electric current driving section 20 which applies a bias current to the p-side electrode 8, and a modulation or dithering signal applying section 21 which applies a modulation frequency signal which modulates the bias current. The modulation frequency signal output from the modulation signal applying section 21 is superposed on the bias current at a connection point 22, and a superposed signal on which the modulation frequency signal is superposed is applied to the p-side electrode 8.

This modulation frequency signal is a sine-wave signal of 10 to 100 kHz and has an amplitude value of about 0.1 to 10% of the bias current and prefers an amplitude value of 1 to 3% degree. The modulation frequency signal is not limited to the sine-wave signal and may be a periodic signal such as a triangular signal. Then, since the periodic signal such as a triangular signal includes a plurality of sine-wave components, the sine-wave signal is preferable as the modulation frequency signal.

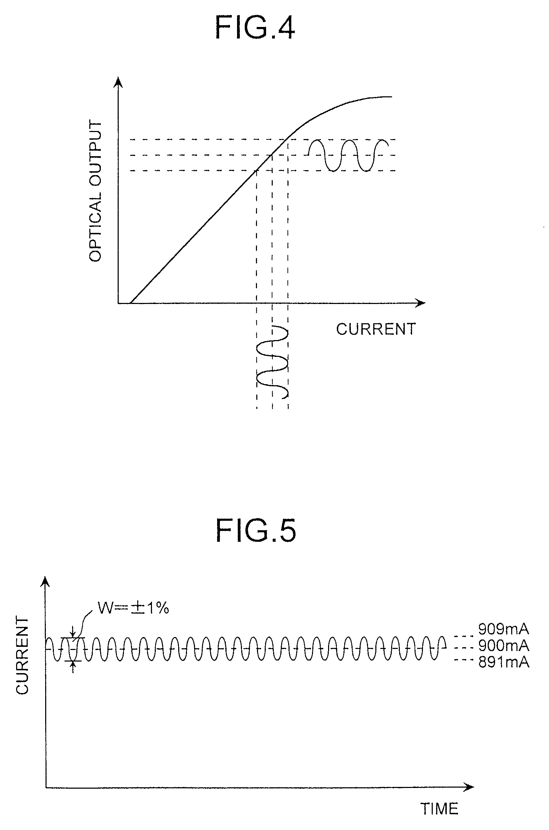

Fig. 3 is a diagram, which shows a change of time of an optical output at the time of driving by the superposed signal in which the modulation frequency signal is superposed on the bias current. In Fig. 3, the modulation frequency signal is a sine-wave signal having an amplitude value of 1% of the value of the bias current, and an amplitude of the optical output at the time of the driving only by the bias current is changed by 1% in a sine-wave manner. As shown in Fig. 4, this operation corresponds to when an electric current - optical output (I-L) characteristic of the semiconductor laser device is modulated.

In the modulation area shown in Fig. 4, the I-L characteristic is linear and the degree of modulation for optical output becomes the same as that of the driving electric current that is modulated as per the modulation wavelength signal. Therefore, in this modulation area, the modulation degree is always maintained at 1% only by applying the driving electric current that maintains the amplitude of modulation wavelength signal at 1%, as is shown in Fig. 5. Controlling the modulation degree of optical output thus becomes easy. On one hand, the modulation degree of the driving electric current modulated as per the modulation frequency signal and that of optical output was not the same in the area where the optical output was amplified. In that case, the amplitude value of modulation frequency signal is adjusted and controlled such that the modulation degree of the optical output becomes 1%, as shown in Fig. 3.

When the value of the driving current to be applied to the semiconductor laser device changes in this way, a refractive index n of the radiation area of the laser beam, such as the active layers 4a and 4b changes. When the refractive index n changes, an optical resonator length Lop also changes. Namely, the optical resonator length Lop is expressed in the following equation:

$$Lop = n \cdot L$$

where L is the physical length of the resonator. The optical resonator length Lop changes according to a change of the refractive index n. When the optical resonator length Lop changes, a resonator wavelength also changes in the Fabry-Perot type. Namely, the resonator wavelength also changes in a sine-wave manner.

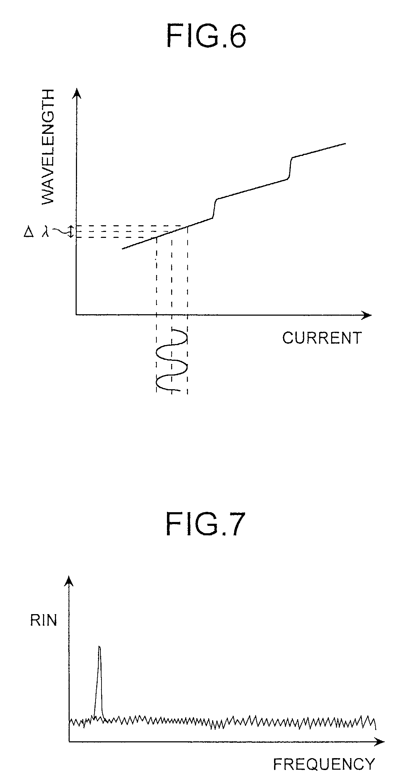

Fig. 6 shows a change of the wavelength with respect to a change of the electric current in the semiconductor laser device. As shown in Fig. 6, the refractive index n changes with the change of the electric current as mentioned above, and a wavelength of the longitudinal oscillation mode slightly changes with the change of the refractive index. When the change of the electric current is large, the longitudinal oscillation mode hops to an adjacent longitudinal oscillation mode so that the wavelength of the longitudinal oscillation mode changes abruptly. Therefore, the modulation frequency signal should be such that the electric current is changed slightly in the range of a slight change of the wavelength.

This modulation frequency signal becomes a noise component. Fig. 7 is a diagram, which shows a relationship between the frequency and a relative intensity noise (RIN). A modulation frequency signal component of low frequency has a large RIN value, but this frequency area has been known and is not used as a signal amplifying area.

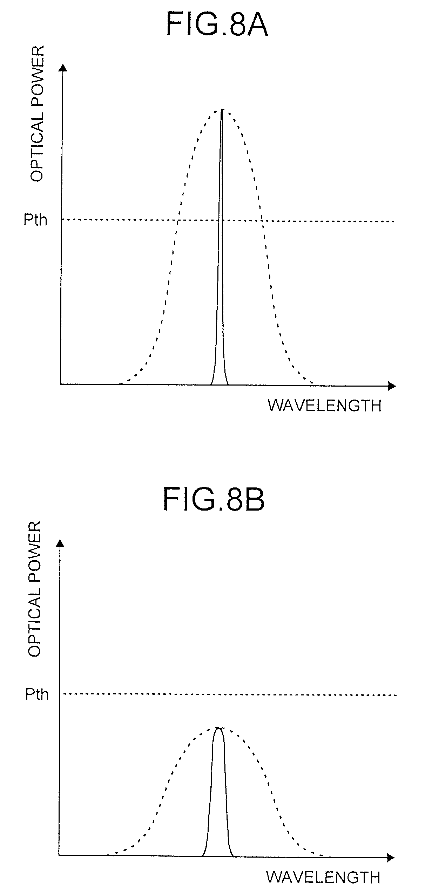

The change of the wavelength with the change of the electric current results in an increase in the spectrum width of the longitudinal oscillation mode. Fig. 8A and Fig. 8B are diagrams that show spectrum waveforms of the longitudinal oscillation mode when the modulation frequency signal is not superposed and when the modulation frequency signal is superposed. Fig. 8A shows a spectrum waveform of the longitudinal oscillation mode when the modulation frequency signal is not superposed, and Fig. 8B shows a spectrum waveform of the longitudinal oscillation mode when the modulation frequency signal is superposed. The spectrum width of the longitudinal oscillation mode shown in Fig. 8A increases further with the change of the wavelength, and when the same optical output is obtained (Fig. 8A and Fig. 8B) the peak value decreases. As a result, when the modulation frequency signal is superposed, the threshold value Pth of stimulated Brillouin scattering can be relatively increased.

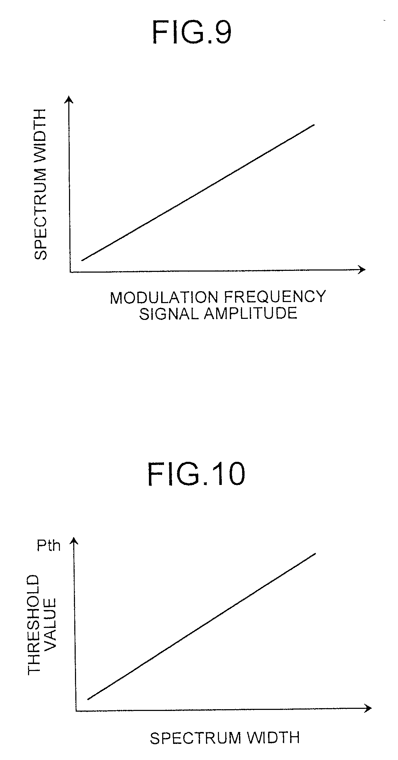

In general, as shown in Fig. 9, when the amplitude value of the modulation frequency signal is increased, the spectrum width of the longitudinal oscillation mode increases, and as shown in Fig. 10, when the spectrum width increases, the threshold value Pth of the stimulated Brillouin scattering increases with respect to the optical output. Therefore, the semiconductor laser device, which is capable of reducing the stimulated Brillouin scattering and which provides a stable and high optical output, can be realized.

The refractive index in semiconductor single crystal changes according to an electric current flowing in the single crystal. In general, when the flowing electric current is larger, the refractive index of the semiconductor single crystal becomes larger accordingly. Therefore, in the semiconductor laser device according to the first embodiment, the refractive index of the semiconductor single crystal composing the stripes 15 and 16 fluctuates due to the existence of the injection current at the time of the laser oscillation.

The first embodiment adopts the W-stripe structure. In a semiconductor laser device having a conventional W-stripe structure, physical lengths of the resonators in the respective stripes are equal with each other, and it is structured such that the injection current is injected uniformly into each stripe. For this reason, the wavelengths of the laser beams radiated from the respective stripes are completely equal with each other. Meanwhile, in the semiconductor laser device according to the first embodiment, as for the wavelengths of the laser beams radiated from the respective stripes 15 and 16, since the spectrum width is widened, a wavelength matching percentage is reduced, and an oscillation characteristic which is closer to the state in which independent semiconductor light emission elements are combined can be obtained in comparison with the semiconductor laser device having the conventional W-stripe structure. Therefore, in the semiconductor laser device of the first embodiment, DOP is expected to be reduced unlike the semiconductor laser device having the conventional W-stripe structure.

Actually as a result of using the semiconductor laser device of the first embodiment as the excitation light source in the Raman amplifier, the inventors of the present invention have confirmed that a substantially constant amplified gain is obtained regardless of a polarization direction of a signal light. Therefore, the semiconductor laser device of the first embodiment is suitable for the excitation light source in the Raman amplifier.

Moreover, in the semiconductor laser device according to the first embodiment, the stripes 15 and 16 have the same structure. Therefore, the semiconductor laser device according to the first embodiment has an advantage of easy production. Moreover, it also has an advantage that it can be produced easily using a conventional producing apparatus.

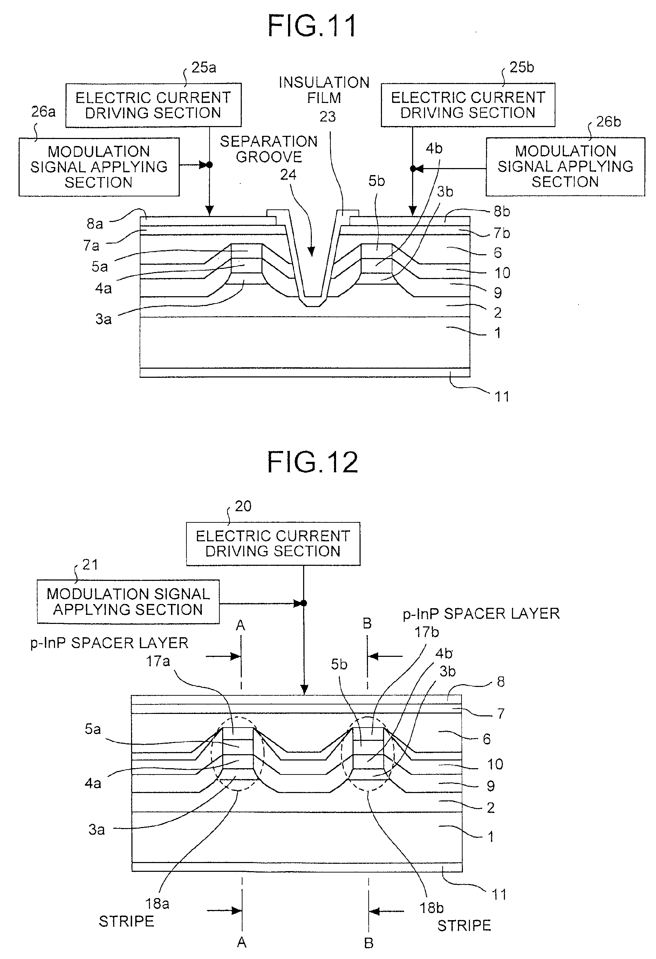

The second embodiment of the present invention will be explained. Fig. 11 is a front sectional view in a longitudinal direction of the semiconductor laser device according to the second embodiment of the present invention. In this semiconductor laser device, a separation groove 24, which goes down to a depth from the p-side electrode 8 to the n-InP cladding layer 2, is formed between the stripes 15 and 16. The surface of the separation groove 24 is covered by an insulating film 23 so that the stripe 15 is electrically separated from the stripe 16.

Further, electric current driving sections 25a and 25b and modulation signal applying sections 26a and 26b, which are independent from the separated p-side electrodes 8a and 8b, are provided. The modulation signal applying sections 26a and 26b respectively output modulation frequency signals having different frequencies. The electric current driving sections 25a and 25b may be formed as one electric current driving section. As a result, phases of superposed signals to be applied to the stripes 15 and 16 are different from each other, and thus when such a semiconductor laser device is used as the excitation light source of the Raman amplifier, DOP of a polarization-multiplexed laser beam can be reduced more easily.

The modulation signal applying sections 26a and 26b may be made to output modulation frequency signals having opposite phases. When it is made so, the modulation signal applying section 26b may serve as a phase shifter which uses a modulation frequency signal to be output by the modulation signal applying section 26a, and which outputs a modulation frequency signal having an opposite phase to the former modulation frequency signal. As per the output of modulation frequency signal having opposite phases, the polarization of laser beam emitted from the stripes 15 and 16 becomes uniform and the laser beam of low noise is expected to be output finally.

In addition, the frequencies of the modulation frequency signals to be output by the modulation signal applying sections 26a and 26b can be made so as not be different but equal with each other, and so they may output modulation frequency signals having different phases.

The first and second embodiments explained the Fabry-Perot semiconductor laser device, and the above structure can be applied to a semiconductor laser device having a wavelength selecting unit of DFB (Distributed Feedback) or DBR (Distributed Bragg Reflector). When such a semiconductor laser device is used as the excitation light source of the Raman amplifier, even when a fiber grating for wavelength selection is not used, an optical output in which the oscillation wavelength is stabilized can be obtained.

The semiconductor laser device according to a third embodiment of the present invention will be explained next. In the semiconductor laser device according to the third embodiment, the same reference numerals are assigned to the same components as those in the first embodiment.

Fig. 12 is a sectional view, which shows a structure in the longitudinal direction of the semiconductor device according to the third embodiment of the present invention. In Fig. 12, the semiconductor laser device has a structure that a p-InP spacer layer 17a is laminated on the upper section of the GRIN-SCH layer 5a in the stripe 18a and a p-InP spacer layer 17b is laminated on the upper section of the GRIN-SCH layer 5b in the stripe 18b.

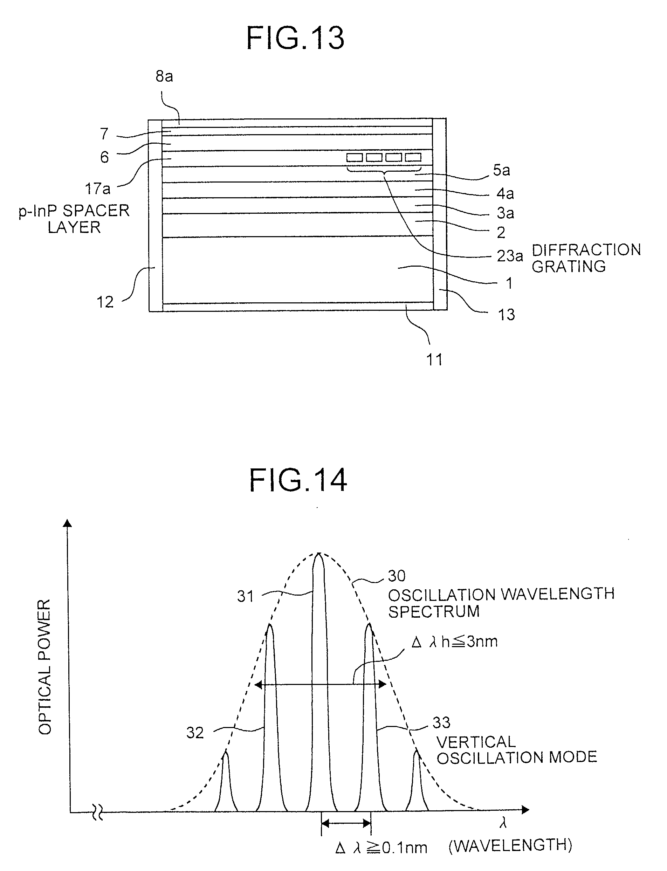

Fig. 13 is a longitudinal sectional view of the semiconductor laser device shown in Fig. 12 taken along the line A-A. A section taken along the line B-B shown in Fig. 12 is the same as the section taken along the line A-A shown in Fig. 13. In Fig. 13, the semiconductor laser device has a structure that a diffraction grating 23a is arranged on one area in the p-InP spacer layer 17a. A diffraction grating 23b corresponding to the diffraction grating 23a is provided on the stripe 18b side.

These diffraction gratings 23a and 23b are composed of p-InGaAsP and have a film thickness of 20 nm and a length of 50 µm in the laser emission direction (lateral direction in Fig. 13). Moreover, a period of the each of the diffraction gratings is 220 nm which is considered a constant pitch . For this reason, a laser beam having a plurality of longitudinal oscillation modes with a center wavelength of 1480nm can be selected.

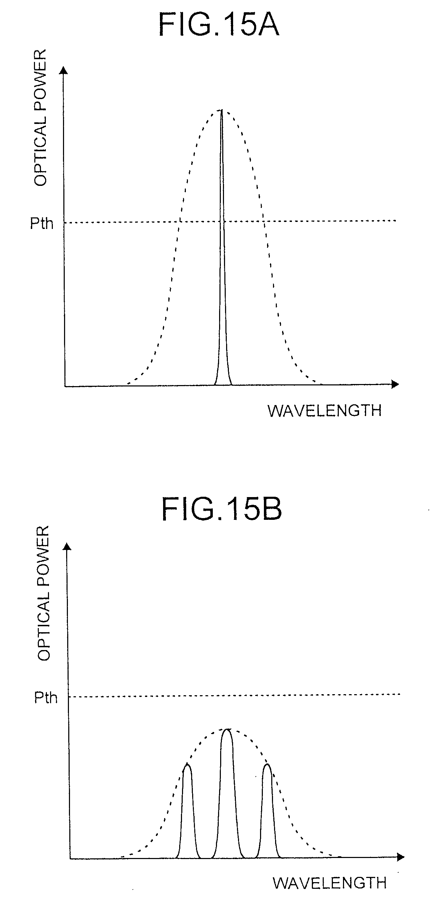

The characteristic owing to the provision of the diffraction gratings 23a and 23b will be explained with reference to Fig. 14, Fig. 15A, and Fig. 15B. Here, the explanation will be given on the assumption that an injection current is injected only into the stripe 18a.

The semiconductor laser device in the third embodiment is based on a precondition that the device is used as an excitation light source of the Raman amplifier, and its oscillation wavelength $\lambda_0$ is 1100 nm to 1550 nm, and the resonator length L is between 800 µm and 3200 µm, both limits included. In general, a mode spacing $\Delta\lambda$ of a longitudinal mode generated by the resonator of the semiconductor laser device can be expressed in the following equation:

$$\Delta\lambda = \lambda_0^2/(2 \cdot n \cdot L)$$

where n is the effective refractive index. When the oscillation wavelength $\lambda_0$ is 1480 nm and the effective refractive index is 3.5, the mode spacing $\Delta\lambda$ is about 0.39 nm when the resonator length L is 800 µm, and it is about 0.1 nm when the resonator length L is 3200 µm. That is, as the resonator length L becomes longer, the mode spacing $\Delta\lambda$ of the longitudinal mode becomes narrower, and the selection condition to oscillate the laser beam of a single longitudinal mode becomes strict.

On the other hand, in the third embodiment, the diffraction grating 23a selects a longitudinal mode by a Bragg wavelength thereof. The selection wavelength characteristic of the diffraction grating 23a is expressed as an oscillation wavelength spectrum 30 shown in Fig. 14.

As shown in Fig. 14, in the third embodiment, a plurality of longitudinal oscillation modes are made to exist in a wavelength selection characteristic expressed by a half-width $\Delta\lambda h$ of the oscillation wavelength spectrum 30 by the semiconductor laser device having the diffraction grating. In the conventional DBR semiconductor laser device or the DFB semiconductor laser device, when the resonator length L is set to 800µm or more, a single longitudinal mode oscillation is difficult to obtain so that a semiconductor laser device having such a resonator length L is not used. In the semiconductor laser device of the second embodiment, however, by positively setting the resonator length L to 800µm or more, a laser beam is output while including a plurality of longitudinal oscillation modes in the half-width $\Delta\lambda h$ of the oscillation wavelength spectrum. In Fig. 14, three longitudinal oscillation modes 31 to 33 are included in the half-width $\Delta\lambda h$ of the oscillation wavelength spectrum.

When a laser beam having a plurality of longitudinal oscillation modes is used, it is possible to suppress a peak value of the laser output and to obtain a high laser output value as compared with when a laser beam of single longitudinal mode is used. For example, the semiconductor laser device shown in the third embodiment has a profile shown in Fig. 15B, and can obtain a high laser output with a low peak value. Whereas, Fig. 15A shows a profile of a semiconductor laser device having a single longitudinal mode oscillation when the same laser output is obtained, and has a high peak value. Further, as described in the first and second embodiments, since a modulation frequency signal is superposed on the bias current, the spectrum width of the respective longitudinal oscillation modes becomes wide, and thus a higher laser output can be obtained with a lower peak value.

As explained in the first embodiment, when the semiconductor laser device is used as an excitation light source for the Raman amplifier, it is preferable to increase an excitation optical output power in order to increase a Raman gain, but when the peak value is high, there is a problem in that stimulated Brillouin scattering occurs and noise increases. Occurrence of the stimulated Brillouin scattering has a threshold value Pth at which the stimulated Brillouin scattering occurs. When obtaining the same laser output power, as shown in Fig. 15B, its peak value is suppressed by providing a plurality of longitudinal oscillation modes and widening the spectrum width so that a high exciting optical output power can be obtained within the threshold value Pth of the stimulated Brillouin scattering. As a result, a stable and high Raman gain can be obtained.

The mode spacing $\Delta\lambda$ between the longitudinal oscillation modes 31 to 33 is 0.1 nm or higher. This is because when the semiconductor laser device is used as an excitation light source for the Raman amplifier, when the mode spacing $\Delta\lambda$ is 0.1 nm or less, the probability that the stimulated Brillouin scattering occurs becomes high. As a result, it is preferable that the resonator length L is 3200μm or less.

From the above viewpoint, it is preferable that the number of longitudinal oscillation modes included in the half-width $\Delta\lambda$h of the oscillation wavelength spectrum 30 is plural. In the Raman amplification, since the amplified gain has a polarization dependency, it is necessary to reduce the influence by a deviation between the polarization direction of the signal light and the polarization direction of the exciting light. There exists a method of depolarizing the exciting light. More specifically, there is a method in which the output lights from two semiconductor laser devices are multiplexed, and a method in which a polarization-maintaining fiber having a predetermined length is used as a depolarizer, to propagate the laser beam emitted from one semiconductor laser device. When the latter method is used, as the number of longitudinal oscillation modes increases, coherence of the laser beam becomes lower. Therefore, it is possible to shorten the length of the polarization-maintaining fiber required for depolarization. Especially, when the number of longitudinal oscillation mode is four or five, the required length of the polarization-maintaining fiber becomes remarkably short. Therefore, when a laser beam emitted from the semiconductor laser device is to be depolarized for use for the Raman amplifier, an emitted laser beam from one semiconductor laser device can be depolarized and utilized easily, without polarization multiplexing the emitted lights from two semiconductor laser devices for use. As a result, the number of parts used for the Raman amplifier can be reduced, and the Raman amplifier can be made compact.

When the oscillation wavelength spectrum width is excessively wide, the coupling loss by the wavelength beam combiner becomes large, and noise and gain fluctuations occur due to the change of the wavelength in the oscillation wavelength spectrum width. Therefore, it is necessary to make the half-width $\Delta\lambda$h of the oscillation wavelength spectrum 30 to 3 nm or less, and ideally, 2 nm or less.

Further, since the conventional semiconductor laser device is used as a semiconductor laser module using a fiber grating, a relative intensity noise (RIN) increases due to the resonance between the fiber grating and the light reflection surface, and Raman amplification cannot be carried out stably. However, according to the semiconductor laser device shown in the third embodiment, since a laser beam emitted from the low reflection film 13 is directly used as an excitation light source for the Raman amplifier, without using the fiber grating, the relative intensity noise is reduced and as a result, fluctuations in the Raman gain decrease, and the Raman amplification can be carried out stably.

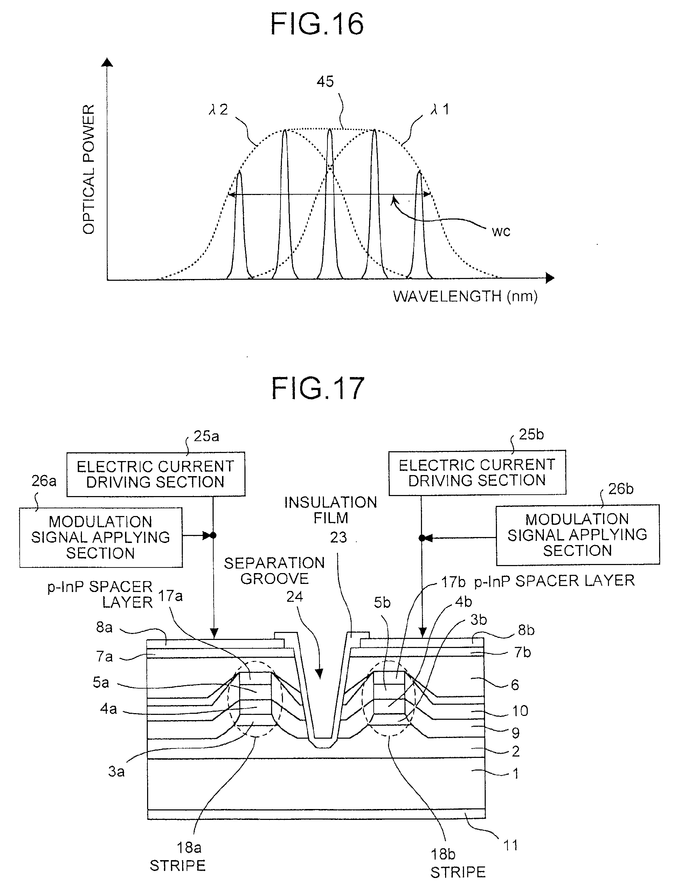

Fig. 16 is a diagram that shows the oscillation wavelength spectrum when the selection wavelength range of the diffraction grating 23a is widened. In Fig. 16, a composite oscillation wavelength spectrum 45, which is generated by widening the wavelength selection range of the diffraction grating 23a, includes four to five longitudinal oscillation modes. As a result, more longitudinal oscillation modes can be selectively output easily as compared with when a plurality of longitudinal oscillation modes are formed based on a single center wavelength. Further, the stimulated Brillouin scattering is reduced and DOP is reduced, and an optical output can be increased.

The fourth embodiment of the present invention will be explained next. The semiconductor laser device according to the fourth embodiment is a semiconductor device where the semiconductor layer device of the second embodiment is applied to the semiconductor laser device of the third embodiment. In other words, as shown is Fig. 17, the p-side electrodes 8 of the respective stripes 18a and 18b are separated from each other by the separation groove 24 and the insulating film 23 so that the p-side electrode 8a of the stripe 18a is separated from the p-side electrode 8b of the stripe 18b.

In the fourth embodiment, in addition to the operation and function of the third embodiment, similar to the second embodiment, different modulation frequency signals can be applied to the stripes 18a and 18b so that the DOP can be further reduced.

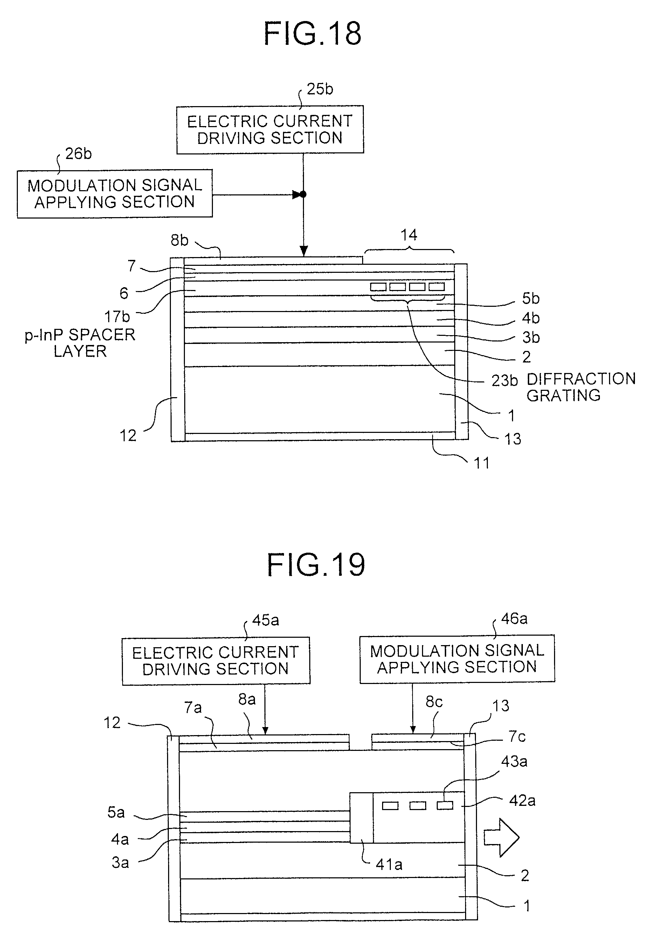

Within p-side electrode corresponding to either one of the stripe 18a or 18b, as shown in Fig. 18, p-side electrode 8b occupies only the area other than the upper area of the diffraction grating 23b so that a current non-injection area 14 may be formed. In general, a refractive index of the semiconductor single crystal changes due to an electric current flowing therein. Since the p-side electrode 8a is arranged along the entire surface of the stripe 18a, the refractive index of the whole area changes. The diffraction grating 23a is unexceptional and since the refractive index changes, an optical waveguide length changes and effective period of the diffraction grating also changes. Therefore, the center wavelength and longitudinal mode to be selected by the diffraction grating 23a actually obtain a value slightly deviated from 1480 nm.

Meanwhile, the stripe 18b has the current non-injection area 14 and its lower section is disposed with the diffraction grating 23b. Therefore, since the injection current does not flow into the diffraction grating 23b and the refractive index of the diffraction grating 23b does not change, a laser beam having plural longitudinal oscillation modes to be selected by strip 18a and a laser beam having plural longitudinal oscillation modes to be selected by the stripe 18b have different center wavelengths and longitudinal mode spacings. As a result, it is the same as that in which independent semiconductor current non-injection area 14 laser elements are provided for the respective stripes 18a and 18b, and thus the DOP can be reduced securely.

Further, stimulated Brillouin scattering is suppressed when semiconductor laser device having length of current non-injection area, 60 μm in longitudinal direction, length of diffraction grating 23b, 50 μm, and having resonator length, 1500 μm, is modulated to change the amplitude value of optical output by 1%, using modulation frequency signal at 30 kHz sine wave.

Further, as shown in Fig. 19, the present invention can be applied also to a structure in which the diffraction grating is not provided along the active layer 4a but a diffraction grating 43a is provided between the active layer 4a and the low reflection film 13. As shown in Fig. 19, optical wave guide 41a and 42a are provided to be adjacent to the active layer 4a, and the diffraction grating 43a is embadded in the optical wave guide 42a. A p-side electrode 8c which is separated from the p-side electrode 8a, which is provided above the active layer 4a, is provided above the diffraction grating 43a. An electric current driving section 45a supplies a bias current to the p-side electrode 8a. A modulation signal applying section 46a applies a modulation frequency signal to the p-side electrode 8c. As a result, the refractive index of the vicinity of the diffraction grating 43a changes according to the modulation frequency signal, and the oscillation wavelength changes and the spectrum width of the longitudinal oscillation mode is widened so that the threshold value Pth of the stimulated Brillouin scattering is increased relatively. Moreover, the spectrum width of the longitudinal oscillation mode becomes wide and wavelengths output from the respective stripes 18a and 18b are different from each other so that the DOP can be reduced.

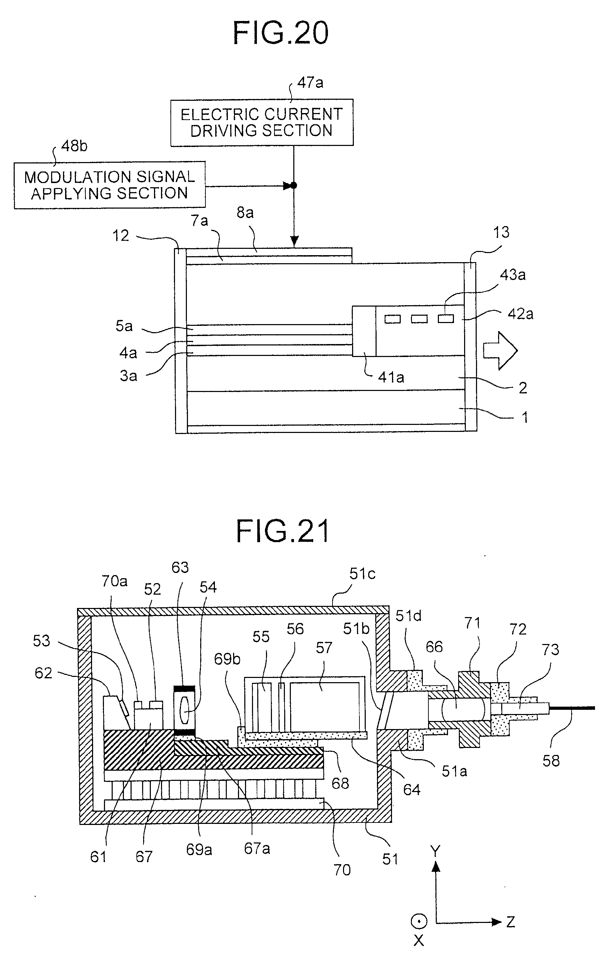

Fig. 20 shows a structure in which the p-side electrode 8c provided above the diffraction grating 43a in the structure shown in Fig. 19 is not provided. The modulation frequency signal output from a modulation signal applying section 48a is superposed on the bias current output from an electric current driving section 47a so that the superposed signal is applied to the p-side electrode 8a. As a result, the refractive index near the active layer 4a changes according to the modulation frequency signal and the oscillation wavelength changes and the spectrum width of the longitudinal oscillation mode becomes wide so that the threshold value Pth of the stimulated Brillouin scattering is increased relatively. Moreover, the spectrum width of the longitudinal oscillation mode becomes wide and the wavelengths output from the stripes 18a and 18b are different from each other so that the DOP can be reduced. The structures shown in Figs. 19 and 20 can be applied also to the first embodiment in which the separation groove 24 is not provided.

The fifth embodiment of the present invention will be explained next. A semiconductor laser module according to the fifth embodiment uses the semiconductor laser device of the first embodiment.

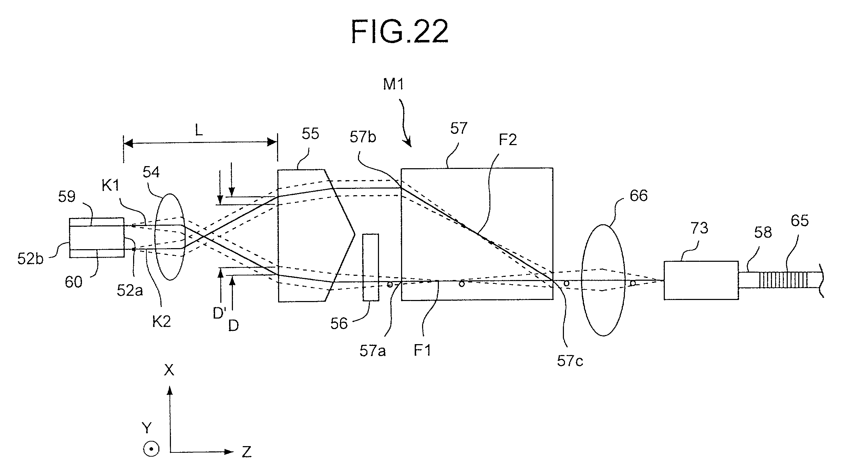

Fig. 21 is sectional view that shows a structure of the semiconductor laser module of the fifth embodiment. Fig. 22 is a frame format of the structure of a semiconductor laser module according to the fifth embodiment of the present invention.

As shown in Fig. 21, the semiconductor laser module of the fifth embodiment has a package 51 inside of which is tightly sealed, a semiconductor laser device 52 which is provided in the package 51 and emits a laser beam, a photodiode 53, a first lens 54, a prism 55, a half-wave plate (polarization rotating device) 56, a polarization beam combiner (PBC) 57 and an optical fiber 58.

As shown in Fig. 22, the semiconductor laser device 52 has stripes 15 and 16 that are formed in parallel on the same plane in the longitudinal direction and are separated. A first laser beam K1 and a second laser beam K2 are emitted respectively from end surfaces of the stripes 15 and 16. In reality, symbols K1 and K2 represent trajectories of the centers of the laser beams. As shown by broken lines, the beams propagate around the centers with a certain expanse. The distance between the stripes 15 and 16 is about 40 μm.

The semiconductor laser device 52 is fixed and mounted onto a chip carrier 61 (see Fig. 21). The semiconductor laser device 52 may be mounted on a heat sink which, in turn, may be mounted on the chip carrier 61.

The photodiode 53 receives a laser beam for a monitor emitted from an end surface 2b on the rear side (left side in Fig. 21) of the semiconductor laser device 52. The photodiode 53 is mounted on a photodiode carrier 62.

The first laser beam K1 emitted from an end surface 2a on the front side (right side in Fig. 21) of the semiconductor laser device 52 and the second laser beam K2 enter the first lens 54, and the first lens 54 converges those beams to different focal positions (F1, F2) so as to widen the distance between the first laser beam K1 and the second laser beam K2.

The first lens 54 is held by a first lens holding member 63 (see Fig. 21). It is preferable that the first lens 54 is located so that the optical axis of the first laser beam K1 emitted from the stripe 15 and the optical axis of the second laser beam K2 emitted from the stripe 16 are approximately symmetrical with respect to the center axis of the first lens 54. As a result, since the first laser beam K1 and the second laser beam K2 pass near the center axis of the first lens 54 as an area where aberration of those beams is small, disorder of the wave surface of the laser beams is eliminated, and thus optical coupling efficiency with the optical fiber 58 becomes high. As a result, the semiconductor laser module with higher output can be obtained. In order to suppress the influence of spherical aberration, a non-spherical lens that has negligible spherical aberration and a high coupling efficiency with the optical fiber 58 is preferably used as the first lens 54.

The prism 55 is provided between the first lens 54 and the polarization beam combiner 57. This prism 55 makes the optical axes of the first laser beam K1 and the second laser beam K2 approximately parallel. The prism 55 is made of optical glass such as BX7 (boro-silicated crown glass). Since the optical axes of the first and second laser beams K1 and K2 propagating from the first lens 54 in an unparallel manner are made parallel to each other by refraction of the prism 55, the polarization beam combiner 57 arranged on the rear side of the prism 55 can be easily produced, and the semiconductor laser module can be miniaturized by miniaturizing the polarization beam combiner 57.

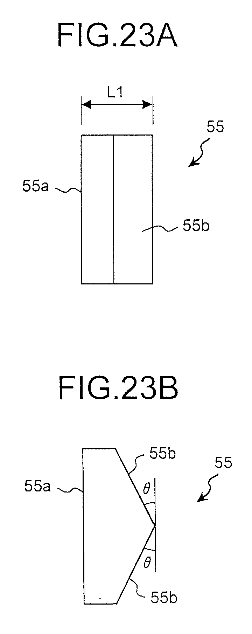

Fig. 23A is a side view that shows the structure of the prism 55. Fig. 23B is a plan view of Fig. 23A. The length L1 of the prism is about 1.0 mm. The prism 55 has an entrance face 55a that is flat and an exit face 55b that is tilted at a specific angle θ, where θ is 32.1° ± 0.1°

Of the first laser beam K1 and the second laser beam K2 that have passed through the prism 55, only the first laser beam K1 enters the half-wave plate 56. This half-wave plate 56 rotates the plane of polarization of the first laser beam K1 by 90°.

The polarization beam combiner 57 has a first port 57a from which the first laser beam K1 enters, a second port 57b from which the second laser beam K2 enters, and a third port 57c. The first laser beam K1 entering from the first port 57a and the second laser beam K2 entering from the second port 57b are multiplexed and output from the third port 57c. The polarization beam combiner 57 is a birefringence element which propagates the first laser beam K1, for example, as an ordinary ray to the third port 57c and propagates the second laser beam K2 as an extraordinary ray to the third port 57c. When the polarization beam combiner 57 is the birefringence element, it is made of $TiO_2$ (rutile), for

example, so that its birefringence index is high and a separation width between the laser beams can be large.

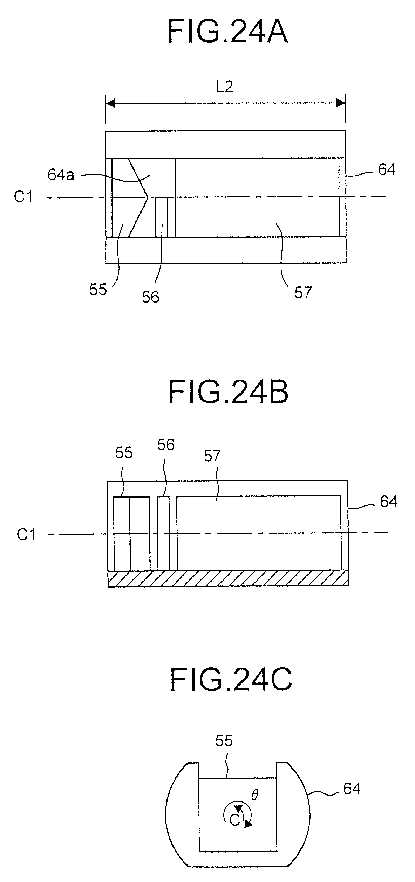

In the fifth embodiment, the prism 55, the half-wave plate 56, and the polarization beam combiner 57 are fixed to the same holder member 64. Fig. 24A is a plan view which shows the holder member 64 which fixes the prism 55, the half-wave plate 56 and the polarization beam combiner 57, and Fig. 24B is a side sectional view of Fig. 24A, and Fig. 24C is a front view of Fig. 24A. As shown in Fig. 24A, Fig. 24B, and Fig. 24C, the holder member 64 is made of a material which can be YAG laser-welded (for example, SUS 403, 304 and the like), its entire length L2 is approximately 7.0 mm, and it is almost columnar. A housing section is formed in the holder member 64. The prism 55, the half-wave plate 56, and the polarization beam combiner 57 are fixed to the housing section. An upper section of the holder member 64 is opened, and its lower section is formed into a flat shape.

As a result, positions around a center axis C1 of the prism 55 and the polarization beam combiner 57 can be easily adjusted so that the first laser beam K1, which enters from the first port 57a of the polarization beam combiner 57 and the second laser beam K2, which enters from the second port 57b are emitted from the third port 57c.

The optical fiber 58 receives the laser beam emitted from the third port 57c of the polarization beam combiner 57 and transmits it to the outside. As shown in Fig. 22, the optical fiber 58 is provided with a light reflection section 65 which reflects a beam of a predetermined wavelength band and is composed of a fiber grating. The beam of the predetermined wavelength is fed back to the semiconductor laser device 52 by the light reflection section 65, the oscillation wavelength of the semiconductor laser device 52 is fixed, and the oscillation spectrum width can be narrowed. Therefore, when an output light from the semiconductor laser module is combined by a wavelength beam combiner (WDM) so as to be used as an excitation light source of an Erbium doped optical fiber amplifier or a Raman amplifier, the loss of the wavelength beam combiner is minimized and a combined light with high output can be obtained. When it is used for a Raman amplifier, the gain fluctuation of the Raman amplification can be suppressed. The light reflection section 65 is formed in such a manner that an ultraviolet light, which becomes interference fringes via a phase mask, for example, is emitted onto the core section of the optical fiber 58 and thus the refractive index is changed periodically.

A second lens 66, which optically combines the laser beam emitted from the third port 57c of the polarization beam combiner 57 with the optical fiber 58, is provided between the polarization beam combiner 57 and the optical fiber 58. The first lens 54 is located so that the first laser beam K1 and the second laser beam K2 form focal points (F1, F2) between the first lens 54 and the second lens 66. As a result, after the first laser beam K1 and the second laser beam K2 pass through the first lens 54, a propagation distance L required for separation (a distance D' in Fig. 11 becomes sufficiently large value) becomes short, and thus the length of the semiconductor laser module in an optically axial direction can be shortened. This makes it possible to provide the semiconductor laser module with high reliability in which time stability of the optical coupling between the semiconductor laser device 52 and the optical fiber 58 is excellent under conditions of high temperature condition.

The chip carrier 61 to which the semiconductor laser device 52 is fixed and the photodiode carrier 62 to which the photodiode 53 is fixed are soldered and fixed to a first base pedestal 67 that has an L-shaped section. The first base pedestal 67 is preferably made of a CuW alloy or the like in order to improve the heat dissipation with respect to heat generation of the semiconductor laser device 52.

The first lens holding member 63 to which the first lens 54 is fixed, and the holder member 64 to which the prism 55, the half-wave plate 56, and the polarization beam combiner 57 are fixed are fixed onto a second base pedestal 68, respectively, via a first supporting member 69a and a second supporting member 69b by YAG laser welding. For this reason, the second base pedestal 68 is preferably made of stainless steel or the like that is a good welding material. Moreover, the second base pedestal 68 is silver-brazed to be fixed onto the flat section 67a of the first base pedestal 67.

A cooler 70 composed of a Peltier element is provided below the first base pedestal 67. A rise in the temperature due to the heat generation from the semiconductor laser device 52 is detected by a temperature adjusting module 70a provided on the chip carrier 61. The cooler 70 is controlled so that the temperature detected by the temperature adjusting module 70a becomes constant. This makes it possible to heighten and stabilize the laser output of the semiconductor laser device 52.

A window section 51b in which the light that has passed through the polarization beam combiner 57 enters is provided in a flange section 51a formed on a side section of the package 51, and an intermediate member 51d is fixed to the end surface of the flange section 51a. A second lens holding member 71 which holds the second lens 66 that condenses the laser beam is fixed into the intermediate member 51d by YAG laser welding. A slide ring 72 made of metal is fixed to the end section of the second lens holding member 71 by YAG laser welding.

The optical fiber 58 is held by a ferrule 73, and the ferrule 73 is fixed into the slide ring 72 by YAG laser welding.

The operation of the semiconductor laser module of the fifth embodiment will be explained. The first laser beam K1 and the second laser beam K2, which are emitted respectively from the front end surfaces 2a of the stripe 15 and the stripe 16 of the semiconductor laser device 52, pass through the first lens 54 to cross each other, and the distance between the beams K1 and K2 is widened and the beams K1 and K2 enter the prism 55. The distance (D) between the first laser beam K1 and the second laser beam K2 is approximately 460 μm when they enter the prism 55. The first laser beam K1 and the second laser beam K2 are made to be parallel with each other by the prism 55 so as to be emitted (their distance becomes approximately 500 μm). After the first laser beam K1 enters the half-wave plate 56 so as to rotate the plane of polarization by 90°, it enters the first port 57a of the polarization beam combiner 57, and the second laser beam K2 enters the second port 57b of the polarization beam combiner 57.

In the polarization beam combiner 57, the first laser beam K1, which enters from the first port 57a and the second laser beam K2, which enters from the second port 57b, are multiplexed so that the multiplexed beam is emitted from the third port 57c.

The laser beam emitted from the polarization beam combiner 57 is condensed by the second lens 66 and enters the end surface of the optical fiber 58 held by the ferrule 73 so as to be transmitted to the outside. Moreover, a part of the laser beam is reflected by the light reflection section 65 of the optical fiber 58, and the reflected light is fed back to the semiconductor laser device 52 so that an external resonator is constituted between the semiconductor laser device 52 and the light reflection section 65. This makes laser oscillation possible in a wavelength band determined by the light reflection section 65.

Meanwhile, the laser beam for monitoring emitted from the rear end surface 2b of the semiconductor laser device 52 is received by the photodiode 53, and a light receiving quantity and the like of the photodiode 53 is calculated so that an optical output and the like of the semiconductor laser device 52 is adjusted.

According to the semiconductor laser module of the fifth embodiment, the first laser beam K1 and the second laser beam K2 are emitted from the semiconductor laser device 52, and the plane of polarization of the first laser beam K1 is rotated by 90° by the half-wave plate 56, and the first laser beam K1 and the second laser beam K2 are polarization-multiplexed by the polarization beam combiner 57. For this reason, a laser beam having a high output and a small degree of polarization can be output from the optical fiber 58. Moreover, since the light reflection section 65 composed of a fiber grating is formed on the optical fiber 58, a laser beam that has a fixed wavelength can be output from the optical fiber 58. Therefore, this semiconductor laser module can be applied as an excitation light source of the Erbium doped optical fiber amplifier requiring a high output or the Raman amplifier requiring low polarization dependency and wavelength stability.

In addition, since only one semiconductor laser device 52 having two stripes emitting two laser beams is used, the time required for locating the semiconductor laser device 52 is shortened. As a result, the time required to produce the semiconductor laser module can be shortened.

Further, since beams are emitted in completely different axial directions from two semiconductor laser devices conventionally, when a semiconductor laser module is not designed taking into consideration the warpage or the like of the package in the respective axial directions, fluctuation of the optical output due to the warpage of the package occurring due to a change of the ambient temperature cannot be suppressed. However, according to the structure of this embodiment, since two lights output from one semiconductor laser device are propagated in almost same direction, the influence of the warpage of the package is suppressed only in one direction so that the intensity of a light output from the optical fiber 58 can be stabilized.

In addition, two lights are output from one semiconductor laser device so that the coupling efficiency of these two lights with the optical fiber 58 fluctuates with respect to the warpage or the like of the package with the same tendency. Therefore, even when the temperature fluctuates, the degree of polarization of the light output from the optical fiber 58 is stabilized.

In the fifth embodiment, the semiconductor laser device according to the first embodiment is used so as to constitute the semiconductor laser module, but the module is not limited to this. The semiconductor laser device of the second embodiment may be used. For example, a semiconductor laser device having a wavelength selection device of the DFB or the DBR may be used, or the semiconductor laser device according to the tenth or fourth embodiment may be used. Furthermore, it is preferable that such a semiconductor laser device is used because this has an advantage that a grating is not required when the optical fiber amplifier is used.

The sixth embodiment of the present invention will be explained. In the sixth embodiment, noise is reduced by applying reverse modulation frequency signal to each stripe of a semiconductor laser device according to the second or fourth embodiment in which the stripes are electrically separated. Further, laser beam emitted from each stripe is polarized combined in the semiconductor laser module according to fifth embodiment. By depolarizing the polarization combined laser beam, the intensity modulation of each plane of polarization is averaged out. In addition, the stimulated Brillouin scattering is also reduced.

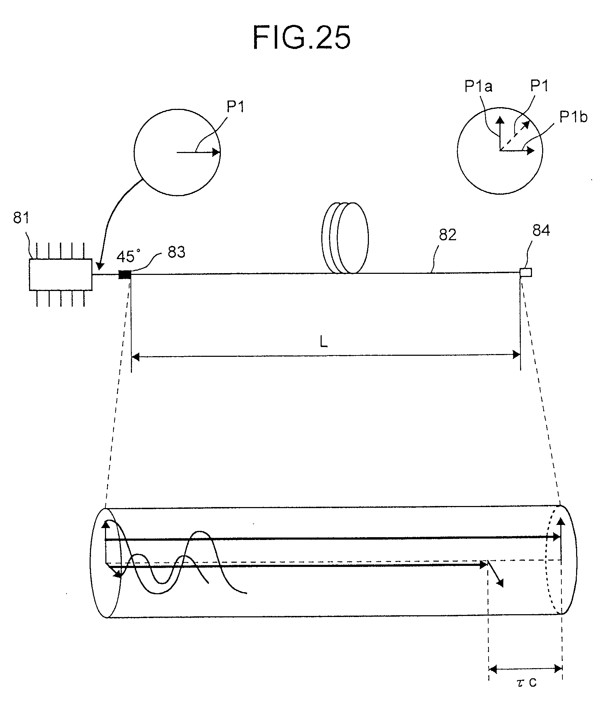

The depolarizer used in the sixth embodiment of the present invention will be explained. Fig. 25 shows a structure of the semiconductor laser device including the depolarizer used in the sixth embodiment of the present invention. In this semiconductor laser, a semiconductor laser element 81 and a polarization-maintaining optical fiber 82 are fused and connected by fuse 83. The fuse 83 is fused with the polarization-maintaining fiber 82 in such a way that the laser beam P1 output from the semiconductor laser element 81 enters the polarization-maintaining fiber 82 with its polarization axis inclined at 45°.

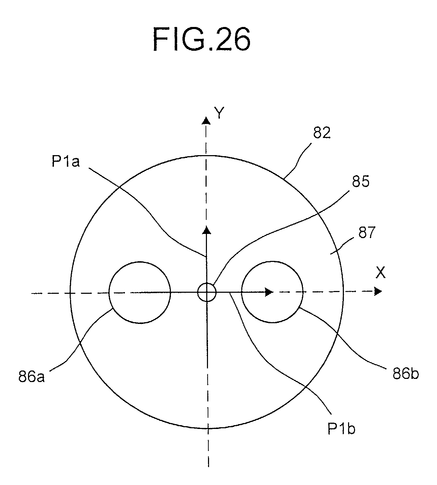

The polarization-maintaining fiber 82 functions as a depolarizer in that it depolarizes the entering laser beam and outputs it from the output end 84. Fig. 26 shows a cross sectional view of the polarization-maintaining fiber (PMF) 82. As can be seen in Fig. 26, there are two circular stress applicators 86a and 86b, one on either side of the core 85. The PMF is a mapped single-mode parent material in which a hole for stress applicators is opened on either side of the core 85. The inside of the hole is buffed at the same time as buffing of the outer surface of the quartz glass rod doped with $B_2O_3$, which is performed in order to increase the linear expansion coefficient. The buffed quartz glass rod is then inserted into the hole. Once the fiber is fabricated by mapping, in the cooling process that follows, the stress applicators 86a and 86b that have a large linear expansion coefficient as compared to the cladding section 87, apply stress to the core 85 due to the pulling.

In this PMF, a stretching stress occurs along the X direction and a compression stress occurs along the Y direction of the core 85, according to the stress occurring in the stress applicators 86a and 86b. Birefringence is induced due to photo-electric effect. The beam propagation speeds in X and Y directions are different. In order for the PMF to function as a depolarizer it is necessary that the optical waveguide difference should be more than the coherence length of each set of orthogonal light beam propagated in X and Y direction, and that the phase correlation between polarization beams should be eliminated. In other words, in order for the PMF to function as a depolarizer it is necessary that between polarization beams there should be a coherent time difference τc corresponding to the optical waveguidedifference that is more than the coherence length.

The semiconductor laser element 81 outputs a single mode laser beam of the DFB laser or the DBR laser. In the not shown optical fiber, the semiconductor laser element 81 emits a laser beam the output terminal 84 and is an excitation light source of the optical fiber amplifier which amplifies the signal light that is transmitted inside of this optical fiber. Further, the peak value of laser output of semiconductor laser element 81 is more than the threshold value of stimulated Brillouin scattering in the optical fiber which is the output destination and is less than twice the threshold value.

The polarization axis of the polarization-maintaining optical fiber 82 is inclined at 45° with respect to the polarization axis of laser beam that is output from the semiconductor laser element 81 so that the output, in other words, the peak value of the laser beam that enters the polarization-maintaining fiber 82 can be vectorially split into two. A time difference that is more than the coherent time difference τc arises between the polarization beams P1a and P1b when they are propagated through the polarization-maintaining optical fiber 82 of length L and they are output as depolarized laser beams from the output terminal 84.

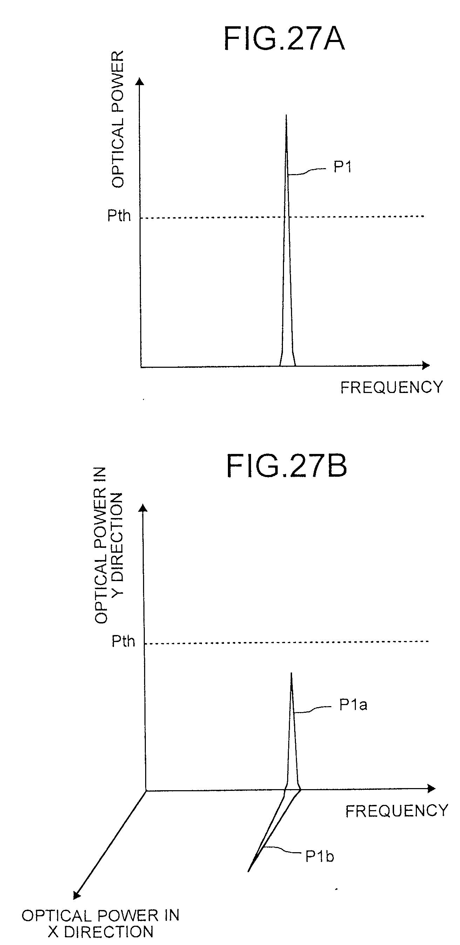

Fig. 27A shows the profile of the laser beam output from the semiconductor laser element 81, and Fig. 27B shows the profiles of each of the polarization beams P1a and P1b output from the output terminal 84. The peak value of laser beam P1 output from the semiconductor laser element 81 is within the range of $1 \sim 2$ times the threshold value Pth of stimulated Brillouin scattering, whereas the peak value of polarization beams P1a and P1b output from the output terminal 84 is less than the threshold value Pth. As a result, the combined output value of each polarization beam P1a and P1b output from output terminal 84 is the same as the output value of the laser beam P1 output from the semiconductor laser element 81. Further, since the peak value of the polarization beams P1a and P1b is half (1/2), the laser beam output from the output terminal is not affected by stimulated Brillouin scattering.

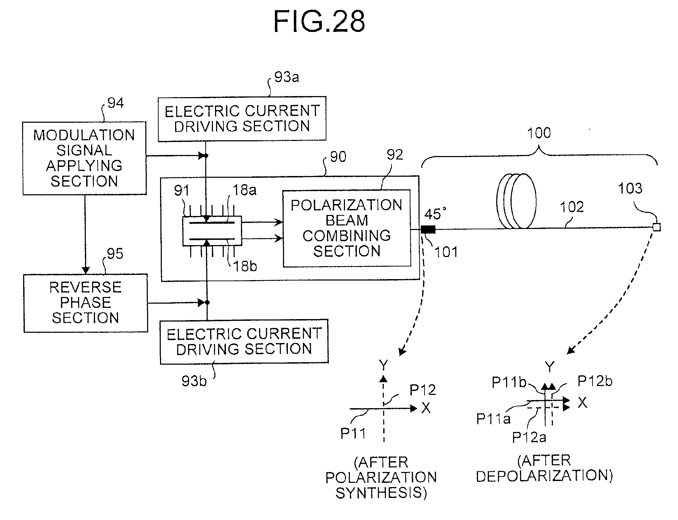

Fig. 28 is a block diagram of a semiconductor laser module according to the fifth embodiment in which a semiconductor laser device according to the fourth embodiment and a depolarizer shown in Fig. 25 are included. As shown in Fig. 28, the semiconductor laser module 90 comprises a semiconductor laser device 91 in which the stripes 18a and 18b of the fourth embodiment that emit multiple longitudinal oscillation mode laser beams. The stripes 18a and 18b are electrically separated and are independently driven by electric current driving sections 93a and 93b, respectively. Modulation frequency signals for each stripe 18a and 18b are superposed and applied by modulation frequency applying section 94. The modulation frequency signal applied to the stripe 18b is converted to a reverse phase by a reverse phase section and therefore has a phase that is opposite to the modulation frequency signal applied to stripe 18a, The semiconductor laser module 90 is compatible with the semiconductor laser module according to fifth embodiment. Further, the electric current driving sections 93a and 93b may be integrated and made into one electric current driving section.

The laser beams P11 and P12 output from the stripes 18a and 18b, respectively, are made to be orthogonal to each other and then combined in a polarization beam combining section 92. Each combined laser beam P11 and P12 is split orthogonally in the X, Y polarization direction by inclining its axis of polarization at 45° and the beam is propagated inside the polarization maintaining fiber 102 in a split form. In other words, the X direction component P11a of the laser beam P11 and the X direction component P12a of the laser beam P12 are propagated inside the polarization maintaining fiber 102. Similarly, the Y direction component P11b of the laser beam P11 and the Y direction component P12b of the laser beam P12 are propagated inside the polarization maintaining fiber 102. The length of the polarization maintaining fiber is such that the time difference is greater than the coherent time difference τc between the X direction component and Y direction component of the laser beam. The laser beams P11a, P11b, P12a and P12b having half the peak value of the laser beams P11 and P12 are output from the output terminal 103.

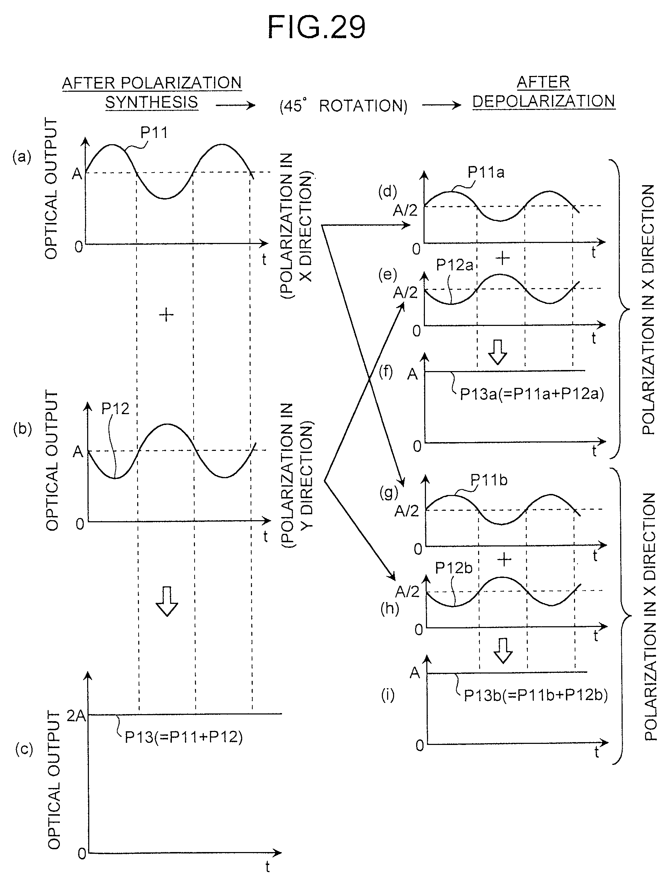

Polarization synthesis and depolarizing of the laser beams P11 and P12 will be explained with reference to the Fig. 29. The laser beam P11 (see (a)), that has an average optical intensity A modulated by a modulation frequency signal is propagated along the X directional plane of polarization. On the other hand, as shown in Fig. 29B, the laser beam P12 (see (b)), that also has an average optical intensity A modulated by a modulation frequency signal of reverse phase to the one in P11, is propagated along Y directional plane of polarization. As a result of this the laser beam after polarization synthesis has an averaged out output and has an optical output of 2A (see (c)). However, the status of the modulation by modulation frequency signals for each plane of polarization is maintained.

Subsequently, the axes of polarization of the laser beams P11 and P12 is inclined at 45° by the fuse 101. Thereafter the laser beams P11 and P12 exit the polarization maintaining fiber 102. Upon being depolarized by the depolarizer 100, the optical output of the laser beams output in X directional plane of polarization P11a and P12a is halved. The two laser beams P11a and P12a have phases that are reverse with respect to each other (see (d), (e), and (f)). However, since the laser beams P11a and P12a are on the same plane, the modulation frequency components having reverse phase relationship are offset and a constant optical output A is achieved in the X directional plane of polarization (see (f)). Similarly, the optical output of the laser beams output in Y directional plane of polarization P11b and P12b is halved. The two laser beams P11b and P12b have phases that are reverse with respect to each other (see (g) and (h)). However, since the laser beams P11b and P12b are on the same plane, the modulation frequency components having reverse phase relationship are offset and a constant optical output A is achieved in the Y directional plane of polarization (see (i)). As a result, the fluctuation of the optical output A in response to the modulation frequency signal and the noise due to modulation frequency are effectively eliminated, and a depolarized laser beam of an optical output 2A is output from the The waveforms (d), (e), (f), and (h) are the same waveforms on time axis but show different speeds of propagation inside the polarization maintaining fiber 102 due to different refractive index inside the polarization maintaining fiber 102.

The semiconductor laser device 91 has multiple longitudinal oscillation modes. The optical spectrum becomes wider according to the modulations due to modulation frequency signals. This has the effect of eliminating stimulated Brillouin scattering. At the same time, the peak value of the optical output is reduced as the laser beam in each longitudinal oscillation mode is depolarized, thereby relatively increasing the threshold value of stimulated Brillouin scattering. Further, the modulation frequency signals have reverse phase relationship and the modulation frequency components are offset, because of which a laser beam with reduced noise component due to modulation frequency signals is output.

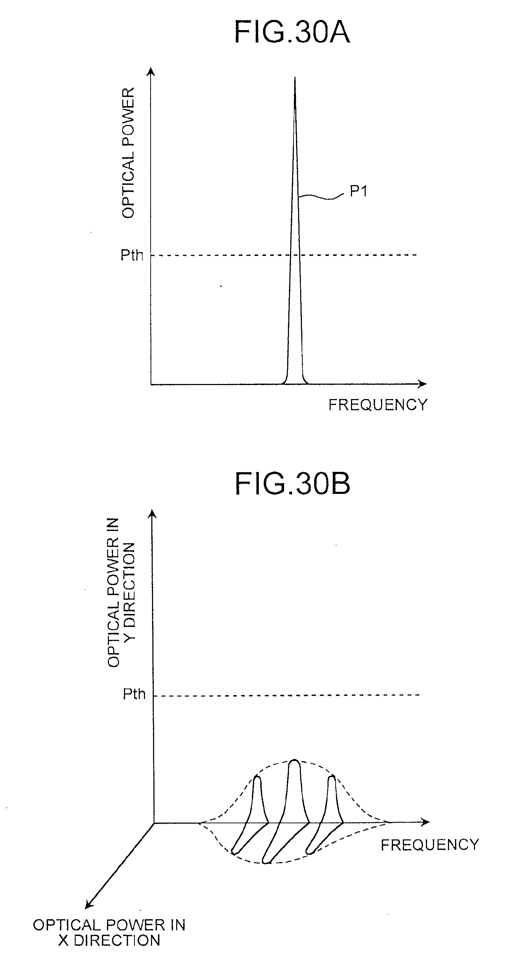

Fig. 30A and Fig. 30B show a case when the semiconductor laser device has three longitudinal oscillation modes. Since each longitudinal oscillation mode is depolarized in the two polarization directions, in effect, there are six longitudinal oscillation modes. In other words, the peak value of a single longitudinal oscillation mode in each of the stripes 18a and 18b can be reduced to 1/6. In other words, a single longitudinal oscillation mode laser beam having a peak value that is six times the threshold value of stimulated Brillouin scattering is obtained. Moreover, the spectrum line becomes wider because of modulation by modulation frequency singals, which decreases the peak value. Therefore a laser beam that is not affected by stimulated Brillouin scattering is realized. Further, as the modulation frequency signals applied to the two stripes 18a and 18b are of reverse phases, the modulation frequency components after depolarization, that takes place subsequent to polarization synthesis, are offset, the laser output obtained is constant and the noise is reduced.

According to the sixth embodiment explained above, the polarization beam combining section 92 is realized by employing optical components. However, in seventh embodiment, the polarization beam combining section 92 is realized by employing an optical fiber type combiner.

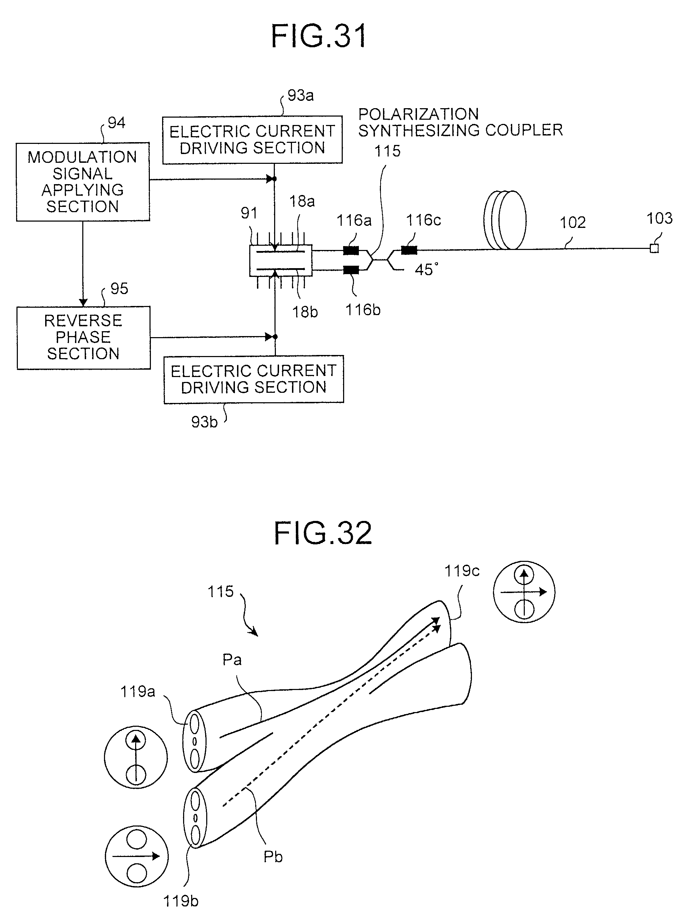

Fig. 31 shows the structure of a semiconductor laser module according to the seventh embodiment. As shown in Fig. 31, in this laser module, a polarization beam combiner 115 is used, instead of the polarization beam combining section 92 that is used in the sixth embodiment. The other components are identical to those in the sixth embodiment and are assigned with the same reference numerals.

As shown in Fig. 32, the polarization beam combiner 115 is fabricated by fusing two polarization maintaining fibers in such a way that their axes of polarization are parallel. A polarization beam Pa that has a plane of polarization in the direction of the stress applicators enters an input terminal 119a. A polarization beam Pb that has a plane of polarization that is at right angles to the direction of the stress applicators enters an input terminal 119b. The propagation speed of the polarization beam Pb is greater than that of the polarization beam Pa. The polarization beams Pa and Pb are polarzation multiplexed at the output terminal 119c by adjusting the propagation coefficient differential, that is, by adjusting the distance of the polarization beam Pb that is propagated at an angle, and the distance of the polarization beam Pa that is propagated in a straight line. Therefore, when the fuses 116a to 116c are fused with the input terminals 119a to 119c, the fuses 116a and 116b are fused in such a way that there is a 90° shift between their planes of polarization.

In the semiconductor laser module according to the seventh embodiment wherein fuses 116a to 116 are used, optical fibers can be employed in the entire length from the semiconductor laser device 91 up to the output terminal 103. Hence the structure of the laser module can be simplified and made compact.

The eighth embodiment of the present invention will be explained. In the eighth embodiment depolarization is carried out using birefringence elements instead of birefringence index of the polarization-maintaining fiber.

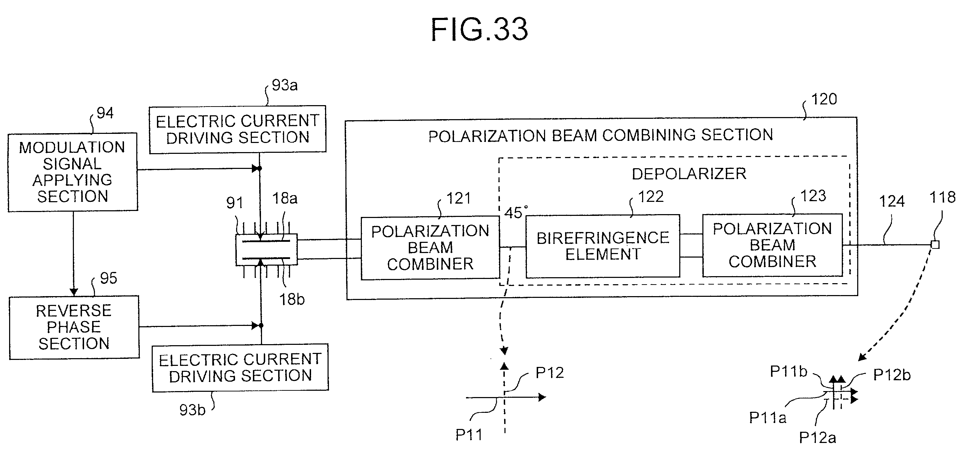

Fig. 33 shows the structure of a laser module according to the eighth embodiment. As shown in Fig. 33, a polarization beam combining section 120 comprises polarization beam combiners 121 and 123, and a birefringence element 122. The birefringence element 122 and the polarization beam combiner 123 function as depolarizers. The polarization beam combiner 121 corresponds to the polarization beam combining section 92, and polarization multiplexes the laser beams P11 and P12 output from the semiconductor laser device 91 and outputs the laser beams to the birefringence element 122 after tilting them by 45°.

A birefringence element is produced from rutile or mono-crystalline quartz. The polarized beams P11 and P12 are accorded the time difference required for depolarization which is more than the coherent time difference τc and output to the polarization combiner 123. The polarization combiner 123 outputs the polarization multiplexed laser beams to the output terminal 118 via the polarization-maintaining fiber 124. Hence, the same advantages as those of sixth and seventh embodiments can be obtained. Ninth The ninthninth embodiment of the present invention will be explained next. In the sixth to eighth embodiments, the birefringence index of polarization maintaining fiber 102 is used for depolarization. However in the ninth embodiment depolarization takes place due to two optical fibers having different lengths such that the propagation time difference between the two optical fibers is greater than the coherent time difference τc.

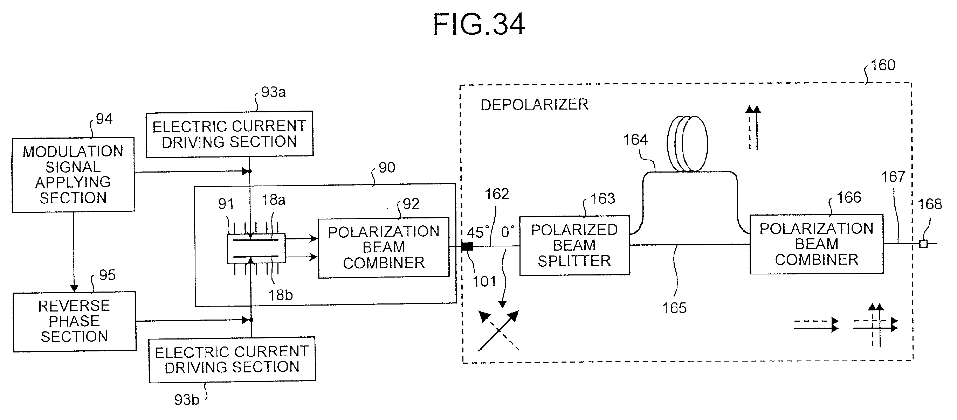

Fig. 34 shows a laser module according to the ninth embodiment where the depolarizer 100 structure shown in Fig. 28 is replaced with another depolarizer 160. As shown in Fig. 34, the laser beam polarization multiplexed by the semiconductor laser module 90 enters a polarization-maintaining fiber 162 at 45° with respect to its axis of polarization. This tilt to the laser beam is given by a fuse 101. The laser beam propagated through the polarization-maintaining fiber 162 enters a polarized beam splitter 163 maintaining the same axis as the axis of polarization (0° tilt) and is split there. One of the polarized beams enters a polarization-maintaining fiber 164 maintaining the same axis as the axis of polarization and the other split polarized beam enters another polarization-maintaining fiber 165, again maintaining the same axis as the axis of polarization. A polarization beam combiner 166 polarization multiplexes the polarization beams entering from the polarization-maintaining fibers 165 and 166. The polarization multiplexed beam passes through another polarization-maintaining fiber 167 is output from an output terminal 168.

The polarization-maintaining fiber 164 is longer than the polarization-maintaining fiber 165. The polarization beams propagated through the polarization-maintaining fiber 164 and 165 are depolarized owing to the fact that the time difference in their propagation is greater than the coherent time difference $\tau c$ at the input terminal of the polarization beam combiner 166.

The difference between the depolarization by the depolarizer 100 and that by the depolarizer 160 is explained. If the spectrum line width of the laser beam to be depolarized is taken as "$\Delta f$" then the coherent time difference $\tau c$ can be calculated based on the expression (1).

$$\tau c = 1/\Delta f \qquad (1)$$

Further, the if refractive index in the two polarization directions is n1 and n2 respectively, propagation time is T1 and distance is L for the polarization beam of refractive index n1, and the propagation time is T2 and the distance is L for the polarization beam of refractive index n2, and "c" is the velocity of light, then T1 and T2 can be calculated based on the expressions (2) and (3):

$$T1 = (L \times n1)/c \qquad (2),$$

$$T2 = (L \times n2)/c \qquad (3).$$

Therefore, as the condition for depolarization is that the time difference $\Delta T(=T1-T2)$ should be more than the coherent time difference $\tau c$,

$$\Delta T = (L/c) \times (n1-n2)$$

$$= (L/c) \times \Delta n > \tau c \qquad (4).$$

As a result, length L of the polarization-maintaining fiber necessary for depolarization will be as follows:

$$L > (1/\Delta f) \times (c/\Delta n) \qquad (5).$$

The refractive index difference for a polarization-maintaining fiber $\Delta n$ is approximately $5 \times 10^{-4}$. If the spectrum line width $\Delta f = 20$ MHz (wavelength width $\Delta\lambda = 0.15$ nm), then from the expression (5), the length L of the polarization-maintaining fiber is more than $3 \times 10^4$ m. Therefore, if a time difference that is greater than the coherent time difference is obtained in the polarization-maintaining fiber, a very long polarization-maintaining fiber will be required, and in order to shorten the length, a polarization-maintaining fiber having a large refractive index $\Delta n$ will be required.

On the contrary, in the depolarizer 160, the propagation time difference depends on the lengths of the polarization-maintaining fibers and not on the difference in the refractive index and depolarization takes place on the condition that the propagation time is greater than the coherent time $\tau c$. In other words, from the expressions (2) and (3), if the lengths of the polarization-maintaining fibers 164 and 165 are L1 and L2, the polarization beam propagation time difference $\Delta T$ between the polarization-maintaining fibers 164 and 165 would be:

$$\Delta T = (n/c) \times (L1-L2)$$

$$= (n/c) \times \Delta L > \tau c \qquad (6).$$

Depolarization takes place if the expression (6) is satisfied.

If the refractive index n of the polarization-maintaining fibers 164 and 165 is taken as 1.5, and spectrum line width $\Delta f = 20$ MHz, the difference in the lengths of the polarization-maintaining fibers 164 and 165 $\Delta L$ that is required for depolarization would be

$$\Delta L > (1/\Delta f) \times (c/n) \qquad (7).$$

Depolarization takes place if the difference $\Delta L$ is above 10 meters.

Particularly, if the spectrum line width $\Delta f$ is 1 MHz and if refractive index is used, the difference in the lengths of the polarization-maintaining fibers that is required for depolarization would be 600 Km. However, if instead the difference in the lengths of the polarization-maintaining fibers $\Delta L$ is used, the difference in the lengths required for depolarization would be 200 m. If the length of one of the polarization-maintaining fibers is negligible, the length of the other polarization-maintaining fiber can be 200 m. Therefore, a depolarizer that functions based on the difference in the lengths of the polarization-maintaining fibers, like the depolarizer 160, is lighter and more compact than the one that functions based on the refractive index, like the depolarizer 100.

In the ninth embodiment described above, the fuse 101 is provided at the side of the polarization beam combining section 92 in such a way that the plane of polarization of the entering laser beam is rotated by 45°. A variation can be that the plane of polarization of the laser beam entering the polarization beam combining section 92 is maintained as it (0°), and the plane of polarization of the laser beam coming out of the beam splitter 163 is rotated by providing a fuse after the beam splitter 163. Yet another variation can be that a 3dB coupler is used in place of the beam splitter 163. When the 3dB coupler is used, the effects almost like that of the ninth embodiment of the present invention are obtained although the optical output corresponding to the plane of polarization is not split precisely into two.

The tenth embodiment of this invention will be explained next. In the sixth embodiment to ninth embodiments, semiconductor laser module of W (double) stripe type according to the second or fourth embodiment is used but in the tenth embodiment two semiconductor laser device of single stripe type are used instead.

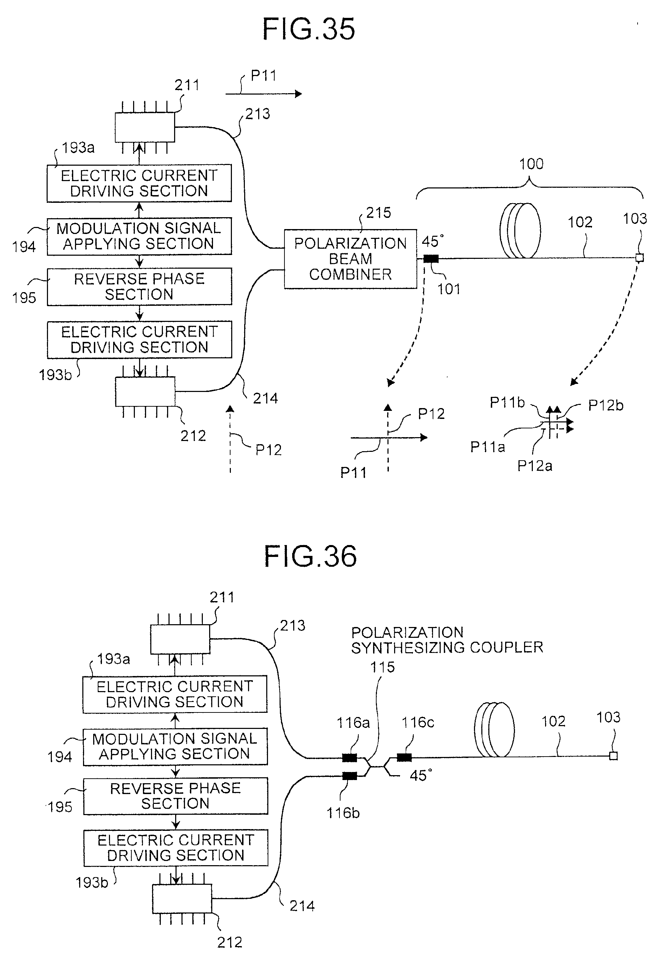

The structure of a laser module structure according the tenth embodiment is shown in Fig. 35. One semiconductor laser device 91 is provided in the laser module shown in Fig. 28, whereas two semiconductor laser devices 211 and 212 are provided in the laser module shown in Fig. 35. In other words, the semiconductor laser device 211 corresponds to stripe 18a of the semiconductor laser device 91 and the semiconductor laser device 212 corresponds to stripe 18b of the semiconductor laser device 91. The electric current driving sections 193a and 193b, the modulation signal applying section 194, the reverse phase section 195, and the polarization beam combiner 215 correspond respectively to the electric current driving sections 93a and 93b, the modulation signal applying section 94, the reverse phase section 95, and the polarization beam combining section 92. The remaining components are common in both Fig. 28 and Fig. 35 and are assigned the same reference numerals.

Each of the semiconductor laser devices 211 and 212 emits a laser beam having a plurality of longitudinal oscillation modes with the same wavelength. The electric current driving sections 193a and 193b drive the semiconductor laser devices 211 and 212, respectively. The modulation signal applying section 194 superposes and applies modulation frequency signal to the semiconductor laser devices 211 and 212. The reverse phase section 195 reverses the phase of the modulation frequency signal applied to the semiconductor laser device 212. Although two electric current driving sections 193a and 193b are shown in Fig. 35, one electric current driving section may be made to drive both the semiconductor laser devices 211 and 212.

Laser beams output from the semiconductor laser devices 211 and 212 are the same as laser beams output from the stripes 18a and 18b, respectively, of the semiconductor laser device 91. Laser beams output from the semiconductor laser devices 211 and 212 are polarization multiplexed by a polarization beam combiner 215 and depolarized by a depolarizer 100. As a result, similar to the sixth embodiment, when the spectrum width of each longitudinal oscillation mode widens due to the modulation frequency signals, the threshold value of stimulated Brillouin scattering can be relatively increased. The threshold value of stimulated Brillouin scatterning increases further with the multiple longitudinal oscillation modes and even further due to depolarization. As a result a high output laser beam can be effectively realized. Further, the modulation frequency signals of opposite phases are offset as a result of depolarization, resulting in suppression of noise accompanying the modulation frequency signals.

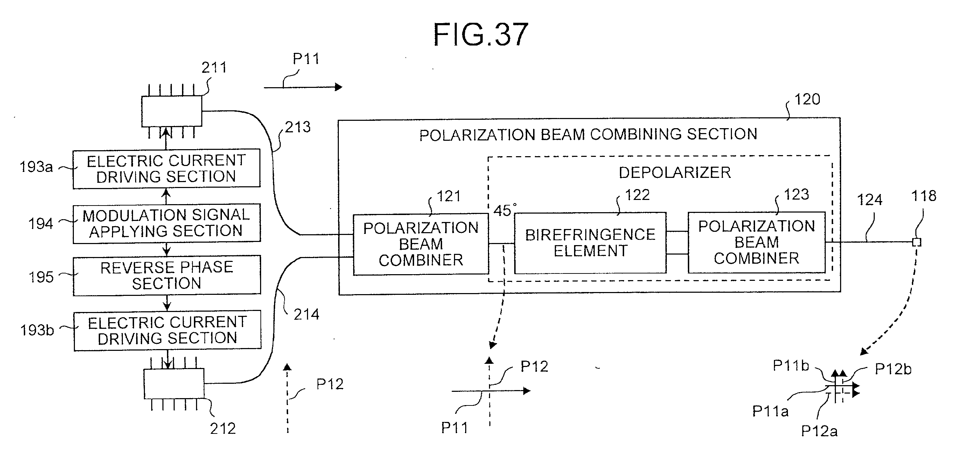

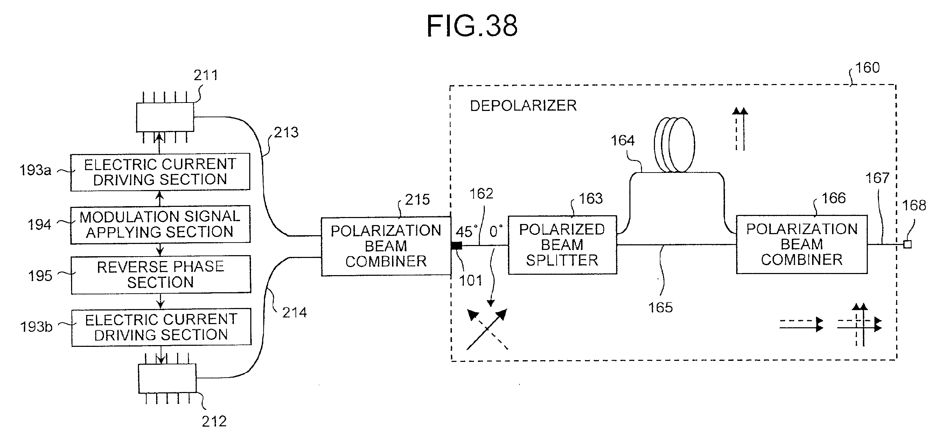

The laser module shown in Fig. 36 is obtained by adapting the laser module according to the seventh embodiment to the tenth embodiment of the present invention, wherein a polarization beam combiner 115 is provided. The laser module shown in Fig. 37 is obtained by adapting the laser module according to the eighth embodiment to the tenth embodiment of the present invention, wherein a birefringence element 122 is provided in the polarization beam combining section 120. The laser module shown in Fig. 38 is obtained by adapting the laser module according to the ninth embodiment to the tenth embodiment of the present invention, wherein a depolarizer 160 is provided. Even though the structures shown in Fig. 36 to Fig. 38 are different, the action is identical to the laser module shown in Fig. 35.

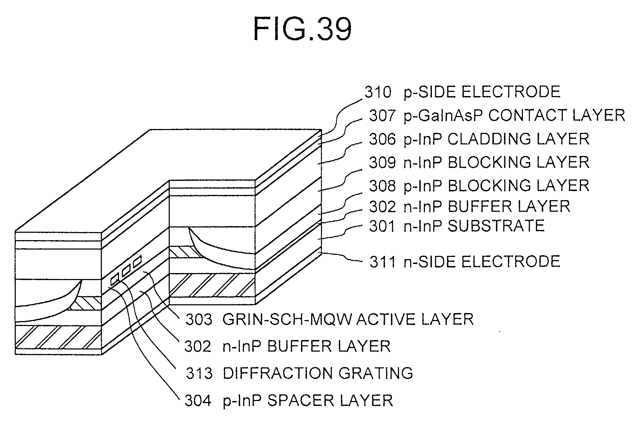

Fig. 39 is a cutaway view of the semiconductor laser device 211 or 212. This semiconductor laser device comprises, from bottom up, an n-InP substrate 301, an n-InP buffer layer 302, a GRIN-SCH-MQW active layer 303, and a p-InP spacer layer 304. The upper section of the n-InP buffer layer 302, the GRIN-SCH-MQW active layer 303, and the p-InP spacer layer 304 form a mesa stripe structure. This mesa stripe structure is oriented in the longitudinal direction of the direction of radiation. Adjacent to this structure a p-InP blocking layer 308 and an n-InP blocking layer 309 are arranged in order. A p-InP cladding layer 306 and a p-GaInAsP contact layer 307 are laminated on the p-InP blocking layer 309 and the n-InP spacer layer 304. Further, a p-side electrode 310 is disposed on the p-GaInAsP contact layer 307 and an n-side electrode 311 is provided on the other surface of the n-InP substrate 301. A diffraction grating 313 is embedded in the p-InP spacer layer 304. At the radiation end surface where the diffraction grating 313 is embedded, a not shown low reflection film is disposed and at the reflection end surface opposite to the radiation end surface a not shown high reflection film is disposed. The n-InP buffer layer 302 also functions as cladding layer.

GRIN-SCH-MQW active layer 303 has a graded index-separate confinement hetero multi quantum well structure and it effectively confines carrier injected from the p-side electrode 310 and the n-side electrode 311. The GRIN-SCH-MQW active layer 303 has multiple quantum well layers and shows a quantum confinement effect in each quantum well layer. High radiation efficiency can be obtained by this confinement effect.

The p-GaInAsP contact layer 307 allows ohmic contact between the p-InP cladding layer 306 and the p-side electrode 310. the p-GaInAsP contact layer 307 is heavily doped with p-type impurities and by having high impurity density ohmic contact with the p-side electrode 310 can be actualized.

The p-InP blocking layer 308 and the n-InP blocking layer 309 perform the function of preventing the injected electric current internally. As the p-side electrode functions as an anode, reverse bias is applied between the p-InP blocking layer 309 and the n-InP blocking layer 308 when voltage is applied. Therefore, the electric current does not flow from the n-InP blocking layer 309 to the n-InP blocking layer 308. The electric current injected from the p-side electrode is prevented and flows in the GRIN-SCH-MQW active layer 303 effectively. Since the electric current flows in effectively, the injected carrier becomes high in the GRIN-SCH-MQW active layer 303 thereby making it possible to increase the radiation efficiency.

The high reflection film has a reflectivity which is greater than 80% and ideally, over 98%. On the other hand, the low reflection film prevents the reflection of laser beam at the radiation end surface. This low reflection film is composed of a film having a reflectivity of less than 5% or, ideally 1%. However, the low reflection film can have other reflectivity values as its reflectivity is optimized according to the resonator length.

The diffraction grating 313 is composed of p-GaInAsP. Since it is composed of semiconductor material, which is different from the surrounding p-InP spacer layer 304, among the laser beams generated from the GRIN-SCH-MQW active layer 303, those that have a specific wavelength are reflected by the diffraction grating 313.

The diffraction grating 313 of length Lg = 50 μm is provided from the low reflection end surface, where a not shown low reflection film of thickness 20 nm is provided, towards the high reflection end surface. The diffraction grating 313 selects a laser beams that has a center wavelength of 1.48 μm that are issued periodically at a pitch of 220 nm. The linearity of driving current-optical output characteristics improves and a stable optical output obtained by keeping the product of the coupling factor κ of the diffraction grating 313 and length Lg of the diffraction grating at 0.3 or less. See Patent No. 2000-134545 for details. When the resonator length L is 1300 μm, it is preferable to keep the length Lg of the diffraction grating to about 300 μm or less so that oscillation takes place in multiple longitudinal oscillation modes. The interval between the longitudinal oscillation modes changes proportionally with the resonator length L. Consequently, the length Lg of the diffraction grating will vary proportionally to the resonator length L. In other words, as the ratio of diffraction grating length Lg: resonator length L as 300 : 1300 is maintained, the relationship between Lg and L for obtaining multiple longitudinal modes by keeping the diffraction grating length Lg at 300 μm can be shown by the following expression

$$Lg \times (1300(\mu m)/L) \leq 300(\mu m)$$

In other words, the diffraction grating length Lg varies proportionally to the resonator length L and is set such that it is 300/1300 times the resonator length L. See Patent No. 2000-134545 for details.

In the tenth embodiment, the semiconductor laser device need not be limited to the type that outputs multiple longitudinal oscillation mode laser beams. Even if the semiconductor laser device is of the Fabry-Perot type, multiple longitudinal oscillation mode laser beams are output. Further, the structures shown in Fig. 18 to Fig. 20 can be applied to the tenth embodiment.

Further, in the sixth to tenth embodiments, it is possible to include the depolarizer in the same chassis.

It is not necessary that the semiconductor laser devices 211 and 212 produce only the multiple longitudinal oscillation mode laser beams. For example, they may produce single mode laser beams as well. Irrespective of whether the semiconductor laser modules produce multiple mode or single mode laser beams, the resulting laser beams have a relatively high threshold value of stimulated Brillouin scattering as a result of widening of the spectrum line width due to modulation signal components. The threshold value of stimulated Brillouin scattering is further relatively pushed up by depolarization that occurs subsequent to polarization synthesis. Also, the noise due to modulation frequency signals is reduced by offsetting the modulation frequency signals.

An optical fiber amplifier according to the eleventh embodiment of the present invention will be explained. In the eleventh embodiment, the semiconductor laser devices and laser modules according to the eighth to tenth embodiments are adapted to the Raman amplifier.

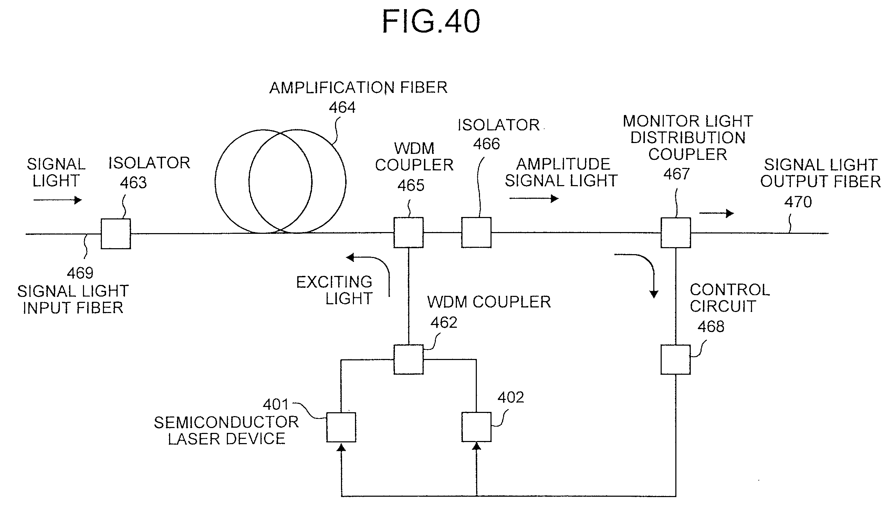

Fig. 40 is a block diagram of a Raman amplifier of the eleventh embodiment of the present invention. This Raman amplifier is used in WDM communication system. The Raman amplifier shown in Fig. 40 includes semiconductor laser devices 401 and 402 that are structurally same as the semiconductor laser device, the semiconductor module or the laser module according to any of the first to tenth embodiments.

The laser beams output from the semiconductor laser devices 401 and 402 and subsequently depolarized have different wavelengths. The two depolarized laser beams are then combined in a WDM coupler 462. The combined laser beam then enters another WDM coupler 465 from which it is output to an amplification fiber 465 as an exciting light. Signal light that is to be amplified enters the amplification fiber 464 in which the exciting light has already entered and is Raman amplified.

The Raman amplified signal line (amplified signal light) first enters the WDM coupler 465, then an isolator 466, and then a monitor light distribution coupler 467. The monitor light distribution coupler 467 outputs one part of the amplified signal light to a control circuit 468 and the remaining part to the signal light output fiber 470 as an output laser beam.

The control circuit 468 controls the intensity of the optical output by the semiconductor laser devices 401 and 402 based on the partial amplified signal light that enters the control circuit and by a feedback mechanism maintains a high-gain Raman amplification of the output laser beam.

As the semiconductor laser devices 401 and 402 are designed to output laser beams that are modulated by modulation frequency signals and further depolarized, the peak values of the longitudinal oscillation modes of the laser beams are minimized. As a result stimulated Brillouin scattering is eliminated due to which high exciting light output can be obtained. Consequently a stable and high-gain Raman amplification is achieved. Also, when reverse phase modulation frequency signals are applied, the modulation frequency signal components can be offset by depolarization that takes place after polarization synthesis. Hence an excitation light source that has reduced noise can be offered.

In the Raman amplifier shown in Fig. 40 the exciting light is excited backward. However, if stable exciting light is output, as output from the semiconductor laser devices 401 and 402, irrespective of whether it is forward-directed pumped, backward-directed pumped or bi-directional pumped, stable Raman amplification can be achieved.

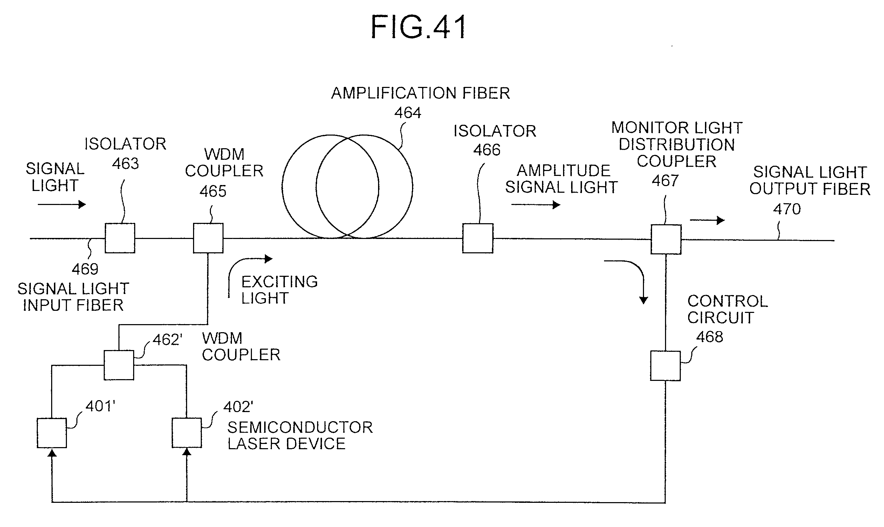

Fig. 41 is a block diagram of a Raman amplifier in which the exciting light is forward-directed. This Raman amplifier is exactly like the one shown in Fig. 40 except for the fact that the WDM coupler 465 is provided next to the isolator 463. The WDM coupler 465 is connected to two semiconductor laser devices 401' and 402' that correspond to the semiconductor laser devices 401 and 402 in Fig. 40, and a WDM coupler 462' that corresponds to the WDM coupler 462 in Fig. 40. The exciting light that is output from the WDM coupler 462' is in the same direction as the signal light. In other words, the exciting light is forward-directed.

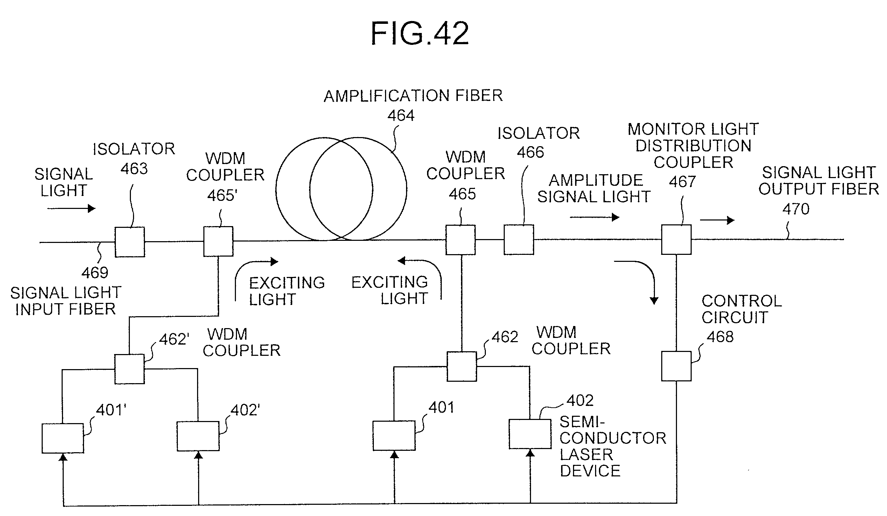

Fig. 42 is a block diagram of a Raman amplifier in which the exciting light is bi-directional. This Raman amplifier has the structure of the Raman amplifier shown in Fig. 40 to which the WDM coupler 465 and the two semiconductor laser devices 401' and 402' shown in Fig. 41 are provided additionally. Bi-directional exciting light is achieved thereby.

It is acceptable even if, of the exciting lights in the two directions, the resonator length L of the exciting light in the forward direction may be less than 800μm. Ordinarily, if the resonator length L is less than 800μm, the interval $\Delta\lambda$ between the longitudinal oscillation modes will become narrow, resulting in fewer longitudinal oscillation modes and consequently less optical output. However, in this case, since the forward directed exciting light has a comparatively lower output than the backward-directed exciting light, the resonator length L need not necessarily be 800μm or greater.

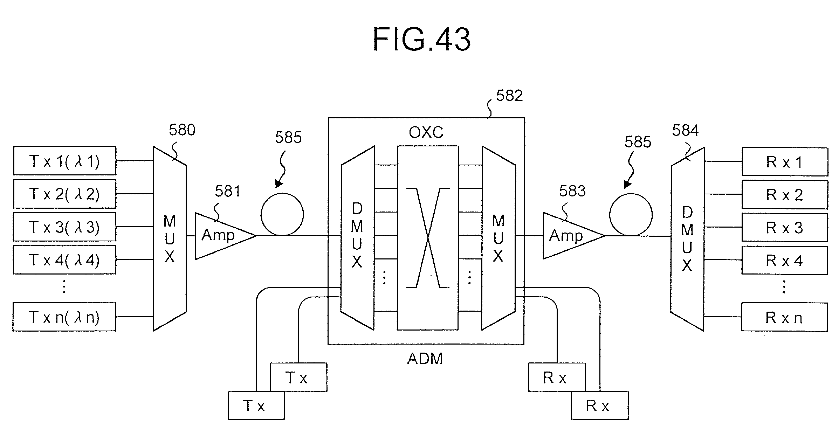

The Raman amplifiers shown in Fig. 40 to Fig. 42 can be adapted to the WDM communication system. Fig. 43 is a block diagram that shows a WDM communication system in which the Raman amplifiers according to Fig. 40 to Fig. 42 are adapted.

In Fig. 43, the light signals of wavelengths $\lambda_1$ to $\lambda_n$ that are transmitted from a plurality of transmitters Tx1 to Txn are multiplexed in a beam coupler 580 and are integrated in one optical fiber 585. A plurality of Raman amplifiers 581 and 583 shown in Fig. 40 to Fig. 42 that amplify week light signals are arranged in the transmission path of the optical fiber 585 based on the distance and these amplifiers amplify the decaying signals. The light signal transmitted along the optical fiber 585 is split into a plurality of light signals of wavelengths $\lambda_1$ to $\lambda_n$ by a beam branching filter 584. The split light signals are received by a plurality of receivers Rx1 to Rxn. The optical fiber 585 may be provided with an Add/Drop Multiplexer (ADM) with which light signals of any wavelength can be added or removed.

In the eleventh embodiment described above, the semiconductor laser device, semiconductor laser module or laser module according to the first to the tenth embodiments have been used as an excitation light source for Raman amplification. However, apart from these, the EDFA of 0.98μm may also be used. Particularly, in the EDFA in which the transmission distance of the exciting light up to the EDF is a few kilometers to a few dozen kilometers, the loss of amplification gain owing to stimulated Brillouin scattering occurring during transmission can be effectively suppressed. Besides, when using reverse phase modulation frequency signals, the modulation frequency signal components can also be suppressed. It is preferable to use modulation frequency signals that are far faster than the Erbium ion transition time. For example, if the transition time of Erbium ion is around 10 ms, EDFA system remains unaffected if modulation frequency signals of over 1 kHz are used.

According to the present invention, in the semiconductor laser device having a W-stripe structure, since a modulation signal generated by the modulation unit is superposed on a bias current, an optical change of the resonator length occurs with the change of the refractive index of the active layer, the spectrum width of the longitudinal oscillation modes between the first laser beam and the second laser beam is widened, and the threshold value of the stimulated Brillouin scattering is increased relatively with respect to the laser beam output. As a result, the stimulated Brillouin scattering can be suppressed and momentary emission wavelengths of the first laser beam and the second laser beam can be made different by the widening of the spectrum width.

According to the present invention, the semiconductor laser device having a W-stripe structure has a predetermined center wavelength due to provision of the diffraction grating and can select a laser beam having a plurality of longitudinal oscillation modes. Thus, the threshold value of the stimulated Brillouin scattering is increased relatively with respect to the laser beam output. Moreover, since the modulation signal generated by the modulation unit is superposed on the bias current, an optical change of the resonator length occurs with the change of the refractive index of the active layer, the spectrum width of the longitudinal oscillation modes between the first laser beam and the second laser beam is widened, the threshold value of the stimulated Brillouin scattering is further increased relatively with respect to the laser beam output, the stimulated Brillouin scattering can be suppressed, and momentary emission wavelengths of the first laser beam and the second laser beam can be made different by the widening of the spectrum width.

According to the present invention, since different electrodes are provided respectively to the active layers of the first stripe structure and the second stripe structure, different modulation signals can be superposed on the respective active layers, matching of a degree of polarization is avoided further, and DOP can be reduced.

According to the present invention, since a modulation signal is a sine-wave signal, widening of the noise component can be suppressed.

According to the present invention, the modulation signal generated by the modulation unit has electrical amplitude of 0.5-10% of the electrical amplitude of the bias current value, and hence the spectrum width of the laser beam can be set to any desired value.

According to the present invention, the modulation signal generated by the modulation unit has optical amplitude of 0.5-10% of the optical amplitude of the bias current value, and hence the spectrum width of the laser beam can be set to any desired value.

According to the present invention, the modulation signals generated by the first modulation unit and the second modulation unit have different frequencies, and this further eliminates matching of the degree of polarization of the respective laser beams, and hence the DOP can be reduced securely.

According to the present invention, the modulation signals generated by the first modulation unit and the second modulation unit have different phases, and this further eliminates matching of the degree of polarization of the respective laser beams, and hence the DOP can be reduced securely.

According to the present invention, the electrode or the first electrode is formed on the current non-injection area other than one section on the upper surface of the first stripe structure, and this makes the refractive index on the first stripe structure and the second stripe structure more distinct so that matching of the degree of polarization of the respective laser beams is eliminated securely, and hence the DOP can be reduced securely.

According to the present invention, the first laser beam and the second laser beam emitted from the semiconductor laser device are polarization-multiplexed so as to be output to the optical fiber so that the stimulated Brillouin scattering can be suppressed, and hence a laser beam having reduced DOP can be emitted.

According to the present invention, a depolarizer is provided to depolarize the output laser beam because of which the peak value of the optical output decreases. Further, the stimulated Brillouin scattering is suppressed. When the modulation signals superposed on the bias current injected into the first stripe structure and the second stripe structure have mutually reverse phase, the noise of the laser beam can be reduced because the modulation signal components are offset for each plane of polarization.

According to the present invention, the semiconductor laser module comprises a first semiconductor laser device that has a first active layer laminated on a semiconductor substrate and that emits a first laser beam, a second semiconductor laser device that has a second active layer laminated on the semiconductor substrate and that emits a second laser beam, an electric current bias unit that injects a bias current into the first active layer and the second active layer, a first modulation unit that generates a first modulation signal which modulates the bias current injected into the first active layer and superposes the first modulation signal on the bias current, a second modulation unit that generates a second modulation signal by dephasing the first modulation signal produced by the first modulation unit by 180° and superposes the second modulation signal on the bias current, a polarization beam combining unit that combines the first laser beam output from the first semiconductor laser device and the second laser beam output from the second semiconductor laser device, and a depolarizer that depolarizes the polarized laser beam output from the polarization beam combining unit. Hence during depolarization, the noise of the laser beam can be reduced because the modulation signal components are offset for each plane of polarization.

According to the present invention, the semiconductor laser module comprises a first semiconductor laser device that has a first active layer laminated on a semiconductor substrate and that emits a first laser beam, a second semiconductor laser device that has a second active layer laminated on the semiconductor substrate and that emits a second laser beam, an electric current bias unit that injects a bias current into the first active layer and the second active layer, a first modulation unit that generates a first modulation signal which modulates the bias current injected into the first active layer and superposes the first modulation signal on the bias current, a second modulation unit that generates a second modulation signal by dephasing the first modulation signal produced by the first modulation unit by 180° and superposes the second modulation signal on the bias current, a polarization beam combining unit that combines the first laser beam output from the first semiconductor laser device and the second laser beam output from the second semiconductor laser device, and a depolarizer that depolarizes the polarized laser beam output from the polarization beam combining unit. Hence during depolarization, the noise of the laser beam can be reduced because the modulation signal components are offset for each plane of polarization.

According to the present invention, the first modulation signal and the second modulation signal are sine-wave signals. Hence the noise component is restrained.

According to the present invention, the modulation signals generated by the first modulation unit and the second modulation unit have an electrical amplitude of 0.5-10% of the electrical amplitude of the bias current value, and hence the spectrum width of the laser beam can be set to any desired value.

According to the present invention, the modulation signals generated by the first modulation unit and the second modulation unit have an optical amplitude of 0.5-10% of the optical amplitude of the bias current value, and hence the spectrum width of the laser beam can be set to any desired value.

According to the present invention, a current non-injection area that suppresses the injected current is disposed in one area of the first active layer and the second active layer. Besides, the current non-injection area is above the first diffraction grating and the second diffraction grating. Hence the change in refractive index of the diffraction gratings can be suppressed and laser beams having desired oscillation wavelength can be obtained.

According to the present invention, the depolarizer is a polarization-maintaining optical fiber, and the input end of the polarization-maintaining optical fiber is connected in such a way that the axis of polarization of the polarization-maintaining optical fiber is rotated by 45° with respect to the axis of polarization of the laser beam output from the polarization beam combining unit. As a result, using a simple structure, stimulated Brillouin scattering and the noise in modulation signal components can be suppressed.

According to this invention, the polarizer uses a birefringence element that divides the input laser beam into two with two orthogonal planes of polarization and depolarizes the laser beam according to the difference in the refractive index; and a post-deflection polarization beam combiner that combines the laser beams output from the birefringence element. Hence the entire semiconductor module can be made compact.

According to the present invention, a polarization beam splitter that rotates the axis of polarization of the input laser beam by 45° and splits the polarization beam into two and the lengths of the polarization-maintaining fibers are such that the difference in the propagation times of the split laser beams in the two is greater than the coherent time. Therefore, even if the laser beam has a narrow spectrum line width, stimulated Brillouin scattering is suppressed and high output achieved.

According to the present invention, the laser beam has a spectrum of plurality of longitudinal oscillation modes, with the coherent time corresponding to the line width of each longitudinal oscillation mode. Therefore stimulated Brillouin scattering is suppressed and high output achieved.

According to the present invention, the polarization combining unit is a polarization beam combiner whose input and output terminals are fused in such a way as to maintain the polarization axes of the two polarization-maintaining fibers. Because of this, the structures other than the semiconductor laser device can be made from optical fibers. As a result, the entire structure can be miniaturized and made lightweight.

According to the present invention, the polarization beam combining unit and the depolarizer are housed in one chassis. As a result, the entire structure can be miniaturized and made lightweight.

According to the present invention, the polarization beam splitter is a 3dB coupler. As a result, the structure can be simplified, stimulated Brillouin scattering suppressed and high output obtained.

According to the present invention, the optical fiber amplifier includes the semiconductor laser device according to any one of claims 1 to 10 or the semiconductor laser module according to any one of claims 11 to 25, an amplification optical fiber, and a coupler that combines the exciting light output from the semiconductor laser device or the semiconductor laser module and the signal light propagated inside the amplification optical fiber. As a result, stimulated Brillouin scattering is suppressed, the noise in modulation signal component is reduced and high output signal light can be obtained.

According to the present invention, the optical fiber amplifier amplifies the signal light by means of Raman amplifier. As a result a stable and high-gain amplification is achieved.

According to the present invention, the amplification optical fiber is an Erbium-doped fiber, and the semiconductor laser device or the semiconductor laser module and the amplification optical fiber are disposed apart from each other. As a result, in EDFA in which remote pumping system is adopted, signal light can be sent over long distances without any reduction in the amplification gain.

Although the invention has been described with respect to a specific embodiment for a complete and clear disclosure, the appended claims are not to be thus limited but are to be construed as embodying all modifications and alternative constructions that may occur to one skilled in the art which fairly fall within the basic teaching herein set forth.

**Claims**

1.   A semiconductor laser device comprising:

a first stripe structure (15) having a first active layer (4a) laminated on one area of a semiconductor substrate (1),said first stripe structure emitting a first laser beam;
a second stripe structure (16) having a second active layer (4b) laminated on another area of the semiconductor substrate (1) ,said second stripe structure emitting a second laser beam;
an electrode (8) laminated on the first active layer (4a) and the second active layer (4b);
an electric current bias unit (20) injecting a bias current into the first active layer (4a) and the second active layer (4b) via the electrode (8); and
a modulation unit (21) generating a modulation signal, wherein the bias current dithers by the modulation signal.

2.   A semiconductor laser device comprising:

a first stripe structure (15) comprising:

a first active layer (4a) laminated on one area of a semiconductor substrate (1); and
a first diffraction grating (23a) arranged on one area in the vicinity of the first active layer (4a), said first diffraction grating selecting a laser beam, said laser beam having a plurality of longitudinal oscillation modes, said laser beam having a specified center wavelength, said first active layer emitting a first laser beam;

a second stripe structure (16) comprising:

a second active layer (4b) laminated on another area of the semiconductor substrate (1); and
a second diffracting grating (23b) arranged on one area in the vicinity of the second active layer (4b), said second diffraction grating selecting a laser beam having a plurality of longitudinal oscillation modes, said laser beam having the specified center wavelength, said second active layer emitting a second laser beam;

an electrode (8) laminated on the first active layer (4a) and the second active layer (4b);
an electric current bias unit (20) injecting a bias current into the first active layer (4a) and the second active layer (4b) via the electrode (8); and
a modulation unit (21) generating a modulation signal, wherein the bias current dithers by the modulation signal.

3.   The semiconductor laser device according to claim 1 or 2, wherein
the electrode (8) has a first electrode (8a) and a second electrode (8b), said electrodes being separately arranged from each other corresponding to the first active layer (4a) and the second active layer (4b); and
the electric current bias unit (20) and the modulation unit (21) respectively have a first electric current bias unit (25a) and a first modulation unit (26a) corresponding to the first electrode (8a), and respectively have a second electric current bias unit (25b) and a second modulation unit (26b) corresponding to the second electrode (8b).

4.   The semiconductor laser device according to any one of claims 1 to 3, wherein the modulation signal generated by the modulation unit (21, 26a, 26b) is a sine-wave signal.

5.   The semiconductor laser device according to any one of claims 1 to 4, wherein the modulation signal generated by the modulation unit (21, 26a, 26b) has an electrical amplitude of 0.5-10% of the electrical amplitude of the bias current.

6.   The semiconductor laser device according to any one of claims 1 to 4, wherein the modulation signal generated by the modulation unit (21, 26a, 26b) has an optical amplitude of 0.5-10% of the optical amplitude of laser output.

7.   The semiconductor laser device according to any one of claims 3 to 6, wherein the modulation signals generated by the first modulation unit (26a) and the second modulation unit (26b) have different frequencies.

8.   The semiconductor laser device according to any one of claims 3 to 6, wherein the modulation signals generated by the first modulation unit (26a) and the second modulation unit (26b) have different phases.

9.   The semiconductor laser device according to claim 8, wherein the modulation signals generated by the first modulation unit (26a) and the second modulation unit (26b) have opposite phases to each other.

10.  The semiconductor laser device according to any one of claims 1 to 9, wherein the electrode (8) or the first electrode (8a) is formed on an upper surface of the first stripe structure (15) except for one section.

11. A semiconductor laser module comprising:

the semiconductor laser device according to any one of claims 1 to 10;
a first lens (54), wherein the first laser beam and the second laser beam emitted from the semiconductor laser device enter into the first lens, said first lens separating to widen the distance between the first laser beam and the second laser beam;
a polarization rotating unit (56) wherein only one of the first laser beam and the second laser beam passed through the first lens (54) enters into the polarization rotating unit, said polarization rotating unit rotating the plane of polarization of the entering laser beam by a predetermined angle;
a polarization beam combining unit (57) comprising:

a first port, wherein (57a) the first laser beam is input from the first lens (54) or the polarization rotating unit (56) ;
a second port (57b), wherein the second laser beam is input from the first lens (54) or the polarization rotating unit (56) ; and
a third port (57c), wherein the first laser beam input through the first port (57a) and the second laser beam input through the second port (57b) are multiplexed at said third port and the multiplexeded laser beam is output from said third port; and

an optical fiber (58) that receives the laser beam output from the third port (57c) of the polarization beam combining unit (57), said optical fiber transmitting it to the outside.

12. The semiconductor laser module according to claim 11, wherein a depolarizer is provided, said depolarizer depolarizing the laser beam output from the optical fiber (58).

13. A semiconductor laser module comprising:

a first semiconductor laser device (211) having a first active layer (4a) laminated on a semiconductor substrate (1), said first active layer emitting a first laser beam;
a second semiconductor laser device (212) having a second active layer (4b) laminated on the semiconductor substrate (1), said second active layer emitting a second laser beam;
an electric current bias unit (194) injecting a bias current into the first active layer (4a) and the second active layer (4b);
a first modulation unit (193a) generating a first modulation signal, said first modulation signal modulating the bias current injected into the first active layer (4a), said bias current dithering by the first modulation signal ;
a second modulation unit (193b, 195) generating a second modulation signal by dephasing the first modulation signal produced by the first modulation unit (193a) by 180°, the bias current dithering by the second modulation signal ;
a polarization beam combining unit (215) combining the first laser beam output from the first semiconductor laser device (211) and the second laser beam output from the second semiconductor laser device (212); and
a depolarizer (100) depolarizing the polarized laser beam output from the polarization beam combining unit (215).

14. A semiconductor laser module comprising:

a first semiconductor laser device (211) comprising:

a first active layer (4a) laminated on a semiconductor substrate (1); and
a first diffraction grating (23a) arranged on one area in the vicinity of the first active layer (4a), said first diffraction grating selecting a laser beam having a plurality of longitudinal oscillation modes, said laser beam having a specified center wavelength, said first active layer emitting a first laser beam;

a second semiconductor laser device (212) comprising:

a second active layer (4b) laminated on the semiconductor substrate (1); and
a second diffraction grating arranged on one area in the vicinity of the second active layer (4b), said second diffraction grating selecting a laser beam having a plurality of longitudinal oscillation modes, said laser beam having a specified center wavelength, said second active layer emitting a second laser beam;
an electric current bias unit (194) injecting a bias current into the first active layer (4a) and the second active layer (4b);
a first modulation unit (193a) generating a first modulation signal, said first modulation unit modulating the bias current injected into the first active layer (4a), said the bias current dithering by the first modulation signal ;

a second modulation unit (193b, 195) generating a second modulation signal by dephasing the first modulation signal produced by the first modulation unit (193a) by 180°, the bias current dithering by the second modulation signal; ;

a polarization beam combining unit (215) combining the first laser beam output from the first semiconductor laser device (211) and the second laser beam output from the second semiconductor laser device (212); and

a depolarizer (100) depolarizing the polarized laser beam output from the polarization beam combining unit (215).

15. The semiconductor laser module according to claim 13 or 14, wherein the first modulation signal and the second modulation signal are sine-wave signals.

16. The semiconductor laser module according to any one of claims 13 to 15, wherein the first modulation signal and the second modulation signal have an electrical amplitude of 0.5-10% of the electrical amplitude of the bias current.

17. The semiconductor laser module according to any one of claims 13 to 15, wherein the first modulation signal and the second modulation signal have an optical amplitude of 0.5-10% of the optical amplitude of laser output.

18. The semiconductor laser module according to any one of claims 13 to 17, wherein a current non-injection area that suppresses the injected current is disposed in one area of the first active layer (4a) and the second active layer (4b).

19. The semiconductor laser module according to any one of claims 12 to 18, wherein the depolarizer (100) is a polarization-maintaining optical fiber (82), and

the input end of the polarization-maintaining optical fiber (82) is connected in such a way that the axis of polarization of the polarization-maintaining optical fiber (82) is rotated by 45° with respect to the axis of polarization of the laser beam output from the polarization beam combining unit (215).

20. The semiconductor laser module according to any one of claims 12 to 18 wherein the depolarizer (100) comprises:

a birefringence element (122) dividing the input laser beam into two with two orthogonal planes of polarization, said birefringence element depolarizing the laser beam according to the difference in the refractive index; and

a post-deflection polarization beam combiner (123) combining the laser beams output from the birefringence element.

21. The semiconductor laser module according to any one of claims 12 to 18, wherein the depolarizer (160) comprises:

a polarization beam splitter (163) splitting the polarization beam into a first polarization beam and a second polarization beam, wherein the polarization beam input to the polarization beam splitter is rotated by 45° with respect to the axis of polarization of the laser beam; a first polarization-maintaining fiber (164) propagating the first polarization beam;

a second polarization-maintaining fiber (165) propagating the second polarization beam, wherein the first polarization-maintaining fiber (164) and the second polarization-maintaining fiber (165) have lengths such that the difference in the propagation times of the laser beams in the two fibers is greater than the coherent time; and

a post-deflection polarization beam combiner (166) combining the polarization beams output from the first polarization-maintaining fiber (164) and the second polarization-maintaining fiber (165).

22. The semiconductor laser module according to any one of claims 12 to 18, wherein the laser beam has a spectrum of plurality of longitudinal oscillation modes, with the coherent time corresponding to the line width of each longitudinal oscillation mode.

23. The semiconductor laser module according to any one of claims 11 to 18, wherein

the polarization combining unit is a polarization beam combiner (115) prepared by fusing two polarization-maintaining fibers (Pa, Pb) in such a way that the direction of polarization of the two polarization-maintaining fibers is maintained, and two polarization-maintaining fibers are fused.

24. The semiconductor laser module according to any one of claims 11 to 18, wherein the polarization combining unit (120) and the depolarizer (100) are housed in one package.

25. The semiconductor laser module according to claim 21, wherein the polarization beam splitter (163) is a 3dB coupler.

26. An optical fiber amplifier comprising:

the semiconductor laser device according to any one of claims 1 to 10 or the semiconductor laser module according to any one of claims 11 to 25;

an amplification optical fiber (464); and

a coupler (465) that combines the exciting light output from the semiconductor laser device or the semiconductor laser module and the signal light propagated inside the amplification optical fiber (464).

**27.** The optical fiber amplifier according to claim 26, wherein the amplification optical fiber (464) amplifies the signal light by means of Raman amplification.

**28.** The optical fiber amplifier according to claim 26, wherein

the amplification optical fiber (464) is an Erbium-doped fiber; and

the semiconductor laser device or the semiconductor laser module and the amplification optical fiber (464) are disposed apart from each other.

# FIG.1

EP 1 318 583 A2

ELECTRIC CURRENT DRIVING SECTION — 20

MODULATION SIGNAL APPLYING SECTION — 21

22

UPPER GRIN-SCH LAYER

5b — 4b ACTIVE LAYER
3b LOWER GRIN-SCH LAYER
8 p-SIDE ELECTRODE
7 p-InGaAsp CONTACT LAYER
6 p-InP CLADDING LAYER
10 n-InP BLOCKING LAYER
9 p-InP BLOCKING LAYER
2 n-InP CLADDING LAYER
1 n-InP SUBSTRATE
11 n-SIDE ELECTRODE

UPPER GRIN-SCH LAYER
5a
4a
ACTIVE LAYER
3a
LOWER GRIN-SCH LAYER

15 STRIPE
16 STRIPE

A    B

# FIG.2

p-SIDE ELECTRODE
8a

7

6
5a
4a
3a
2

1

12
HIGH REFLECTION
FILM

13
LOW REFLECTION
FILM

11

# FIG.3

OPTICAL OUTPUT

W=±1%

323.2mW
320.0mW
316.8mW

TIME

# FIG.4

# FIG.5

# FIG.6

# FIG.7

# FIG.8A

# FIG.8B

# FIG.9

SPECTRUM WIDTH

MODULATION FREQUENCY
SIGNAL AMPLITUDE

# FIG.10

Pth

THRESHOLD
VALUE

SPECTRUM WIDTH

# FIG.11

25a ELECTRIC CURRENT DRIVING SECTION

26a MODULATION SIGNAL APPLYING SECTION

INSULATION FILM 23

SEPARATION GROOVE 24

25b ELECTRIC CURRENT DRIVING SECTION

26b MODULATION SIGNAL APPLYING SECTION

4b

5b

3b

8a
7a
5a
4a
3a

8b
7b
6
10
9
2
1

11

# FIG.12

20 ELECTRIC CURRENT DRIVING SECTION

21 MODULATION SIGNAL APPLYING SECTION

p-InP SPACER LAYER 17b

p-InP SPACER LAYER

17a

A

B

5b

4b
3b
8
7

5a

4a

6
10
9
2

3a

1

11

18a

STRIPE

A

B

18b

STRIPE

# FIG.13

8a
7
6
17a
p-InP SPACER
LAYER
12

5a
4a
3a
2
23a   DIFFRACTION
GRATING
1
13
11

# FIG.14

OPTICAL POWER

31

30
OSCILLATION WAVELENGTH
SPECTRUM

$\Delta \lambda h \leqq 3nm$

32

33
VERTICAL
OSCILLATION MODE

$\lambda$

$\Delta \lambda \geqq 0.1nm$   (WAVELENGTH)

# FIG.15A

# FIG.15B

# FIG.16

OPTICAL POWER

λ2      45      λ1

wc

WAVELENGTH (nm)

# FIG.17

25a
ELECTRIC CURRENT DRIVING SECTION

26a
MODULATION SIGNAL APPLYING SECTION

25b
ELECTRIC CURRENT DRIVING SECTION

26b
MODULATION SIGNAL APPLYING SECTION

INSULATION FILM 23

SEPARATION GROOVE 24

17b  p-InP SPACER LAYER

p-InP SPACER LAYER    17a

5b
4b
3b
8b
7b
6
10
9
2
1
11

8a
7a
5a
4a
3a

18a STRIPE

18b STRIPE

# FIG.18

# FIG.19

# FIG.20

# FIG.21

# FIG.22

EP 1 318 583 A2

## FIG.23A

## FIG.23B

# FIG.24A

L2

64a

C1

64

55

56

57

# FIG.24B

55 56 57

C1

64

# FIG.24C

55

64

$\theta$

C

# FIG.25

# FIG.26

# FIG.27A

# FIG.27B

# FIG.28

MODULATION SIGNAL APPLYING SECTION
94

ELECTRIC CURRENT DRIVING SECTION
93a

REVERSE PHASE SECTION
95

ELECTRIC CURRENT DRIVING SECTION
93b

90

91    18a    18b

POLARIZATION BEAM COMBINING SECTION
92

45°
101

100

102

103

Y
P12
X
P11

(AFTER POLARIZATION SYNTHESIS)

Y
P11b    P12b
X
P11a    P12a

(AFTER DEPOLARIZATION)

# FIG.29

AFTER POLARIZATION SYNTHESIS ⟶ (45° ROTATION) ⟶ AFTER DEPOLARIZATION

# FIG.30A

# FIG.30B

# FIG.31

# FIG.32

# FIG.33

EP 1 318 583 A2

# FIG.34

EP 1 318 583 A2

# FIG.35

211
P11
213
193a
ELECTRIC CURRENT
DRIVING SECTION
194 MODULATION SIGNAL
APPLYING SECTION
195 REVERSE PHASE
SECTION
ELECTRIC CURRENT
DRIVING SECTION
193b
214
212
P12

215
POLARIZATION
BEAM
COMBINER
45°
101
100
102
103

P11
P12

P11b
P12b
P11a
P12a

# FIG.36

211
213
193a
ELECTRIC CURRENT
DRIVING SECTION
194 MODULATION SIGNAL
APPLYING SECTION
195 REVERSE PHASE
SECTION
ELECTRIC CURRENT
DRIVING SECTION
193b
214
212

POLARIZATION
SYNTHESIZING COUPLER
115
116a
116c
102
103
116b
45°

# FIG.37

EP 1 318 583 A2

FIG.38

EP 1 318 583 A2

211

193a ELECTRIC CURRENT DRIVING SECTION

213

194 MODULATION SIGNAL APPLYING SECTION

215

195 REVERSE PHASE SECTION

POLARIZATION BEAM COMBINER

193b ELECTRIC CURRENT DRIVING SECTION

214

212

160

DEPOLARIZER

164

162

163

POLARIZED BEAM SPLITTER

166

167

168

45° 0°

POLARIZATION BEAM COMBINER

101

165

# FIG.39

310 p-SIDE ELECTRODE
307 p-GalnAsP CONTACT LAYER
306 p-InP CLADDING LAYER
309 n-InP BLOCKING LAYER
308 p-InP BLOCKING LAYER
302 n-InP BUFFER LAYER
301 n-InP SUBSTRATE
311 n-SIDE ELECTRODE

303 GRIN-SCH-MQW ACTIVE LAYER
302 n-InP BUFFER LAYER
313 DIFFRACTION GRATING
304 p-InP SPACER LAYER

# FIG.40

AMPLIFICATION FIBER
464

ISOLATOR
466

MONITOR LIGHT
DISTRIBUTION
COUPLER
467

SIGNAL
LIGHT

ISOLATOR
463

WDM
COUPLER
465

AMPLITUDE
SIGNAL LIGHT

SIGNAL LIGHT
OUTPUT FIBER
470

469
SIGNAL LIGHT
INPUT FIBER

EXCITING
LIGHT

WDM COUPLER
462

CONTROL
CIRCUIT
468

401
SEMICONDUCTOR
LASER DEVICE

402

EP 1 318 583 A2

# FIG.41

AMPLIFICATION FIBER
464

ISOLATOR
463

WDM
COUPLER
465

SIGNAL
LIGHT

ISOLATOR
466

AMPLITUDE
SIGNAL LIGHT

MONITOR LIGHT
DISTRIBUTION
COUPLER
467

SIGNAL LIGHT
OUTPUT FIBER
470

469
SIGNAL LIGHT
INPUT FIBER

EXCITING
LIGHT

CONTROL
CIRCUIT
468

462'   WDM
COUPLER

401'

402'
SEMICONDUCTOR
LASER DEVICE

EP 1 318 583 A2

# FIG.42

AMPLIFICATION FIBER
464

ISOLATOR
463

WDM COUPLER
465'

ISOLATOR
466

WDM COUPLER
465

MONITOR LIGHT DISTRIBUTION COUPLER
467

SIGNAL LIGHT

AMPLITUDE SIGNAL LIGHT

SIGNAL LIGHT OUTPUT FIBER
470

469
SIGNAL LIGHT INPUT FIBER

EXCITING LIGHT

EXCITING LIGHT

CONTROL CIRCUIT
468

462'
WDM COUPLER

462
WDM COUPLER

401'

402'

401

402
SEMI-CONDUCTOR LASER DEVICE

EP 1 318 583 A2

FIG.43

# FIG.44

EP 1 318 583 A2